# EUROPEAN PATENT APPLICATION

(11) **EP 4 679 428 A1**
(43) Date of publication of application: **14.01.2026**
(21) Application number: 25176387.6
(22) Date of filing: 14.05.2025
(51) Int. Cl.: G11C 7/10, G11C 8/12, G11C 5/04

(54) **NON-VOLATILE MEMORY DEVICE INCLUDING ON-DIE-TERMINATION CIRCUIT**

(30) Priority: 09.07.2024 KR 20240090675; 01.08.2024 KR 20240102699
(71) Applicant: Samsung Electronics Co., Ltd., Suwon-si, Gyeonggi-do 16677 (KR)
(72) Inventor: YUN, Seunghyeon, 16677 Suwon-si, Gyeonggi-do (KR); KANG, Hyunsuk, 16677 Suwon-si, Gyeonggi-do (KR); KANG, Kyoungtae, 16677 Suwon-si, Gyeonggi-do (KR); BYUN, Jindo, 16677 Suwon-si, Gyeonggi-do (KR); CHOI, Youngdon, 16677 Suwon-si, Gyeonggi-do (KR)
(74) Representative: Kuhnen & Wacker Patent- und Rechtsanwaltsbüro PartG mbB

(57) **Abstract**

Provided is a non-volatile memory device including an input/output (I/O) pin (P11) configured to transfer data to or receive data from a memory controller (20_1), and a plurality of memory dies (100a to 100n) connected to the I/O pin (P11), the plurality of memory dies (100a to 100n) including a target die (100a), a first non-target die (100b), and a second non-target die (100c), wherein the first non-target die (100b) includes a first on-die-termination (ODT) circuit (110b) connected to the I/O pin (P11) and provides a first ODT resistance value (R_{TT2}) based on a first distance between the target die (100a) and the first non-target die (100b), and wherein the second non-target die (100c) includes a second ODT circuit (110c) connected to the I/O pin (P11) and provides a second ODT resistance value (R_{TT3}) based on a second distance between the target die (100a) and the second non-target die (100c), the second ODT resistance value (R_{TT3}) being different from the first ODT resistance value (R_{TT3}).

## Description

### BACKGROUND

Embodiments of the present disclosure relate to a memory device, and more particularly, to a non-volatile memory device including an on-die-termination (ODT) circuit, a storage device including the non-volatile memory device, and an operating method of the storage device.

Storage devices may include a non-volatile memory and a controller for controlling the non-volatile memory. In the related art, communication between a non-volatile memory and a controller has been performed at an operation frequency which is relatively lower than a memory system including a high-speed memory such as dynamic random-access memory (DRAM) or static random-access memory (SRAM). Therefore, signal integrity between a non-volatile memory and a controller is not a very significant factor in total performance of a storage device. However, recently, high-speed operation of storage devices is needed, and thus, signal integrity has been a very significant factor in storage devices, so as to enhance the overall performance of a computing system or a mobile communication system.

### SUMMARY

One or more embodiments provide a non-volatile memory device which may enhance signal integrity when performing a high-speed operation.

According to an aspect of one or more embodiments, there is provided a non-volatile memory device including an input/output (I/O) pin configured to transfer data to or receive data from a memory controller, and a plurality of memory dies connected to the I/O pin, the plurality of memory dies including a target die, a first non-target die, and a second non-target die, wherein the first non-target die includes a first on-die-termination (ODT) circuit connected to the I/O pin and provides a first ODT resistance value based on a first distance between the target die and the first non-target die, and wherein the second non-target die includes a second ODT circuit connected to the I/O pin and provides a second ODT resistance value based on a second distance between the target die and the second non-target die, the second ODT resistance value being different from the first ODT resistance value.

According to another aspect of one or more embodiments, there is provided a storage device including a memory controller, and a plurality of memory dies connected to the memory controller through a first channel, the plurality of memory dies being stacked in a vertical direction on a substrate, wherein each memory die of the plurality of memory dies includes a target die configured to be selected based on a chip enable signal and an address each received from the memory controller, a first non-target die configured not to be selected based on the chip enable signal and the address, and a second non-target die configured not to be selected based on the chip enable signal and the address, wherein the first non-target die provides a first ODT resistance value based on a position of the target die, and wherein the second non-target die provides a second ODT resistance value based on the position of the target die, the second ODT resistance value being different from the first ODT resistance value.

Based on the storage device being powered up, the memory controller may transfer a plurality of ODT values to the plurality of memory dies, and each memory die of the plurality of memory dies may store the received plurality of ODT values in a storage circuit. Based on the storage device operating, the memory controller may transfer changed ODT values to the plurality of memory dies, respectively, and each memory die of the plurality of memory dies may store the changed ODT values in a storage circuit. Each memory die of the plurality of memory dies may update a plurality of ODT values in a storage circuit based on a result of a training operation.

According to still another aspect of one or more embodiments, there is provided a non-volatile memory device including an input/output (I/O) pin configured to transfer data to or receive data from a memory controller, a chip enable pin configured to receive a chip enable signal from the memory controller, and a plurality of memory dies connected in common to the I/O pin and the chip enable pin, the plurality of memory dies being stacked in a vertical direction on a substrate, wherein each memory die of the plurality of memory dies includes a target die configured to be selected based on the chip enable signal and a plurality of non-target dies configured not to be selected based on the chip enable signal, wherein each memory die of the plurality of memory dies is configured to determine operation states of the plurality of memory dies, select an on-die-termination (ODT) value based on the target die from among a plurality of ODT values included in an ODT value table, and provides the selected ODT value, and wherein the ODT value table is configured to store different ODT values based on the target die, with respect to each memory die of the plurality of memory dies.

Each memory die of the plurality of memory dies may include a detection circuit configured to detect a position of the target die, a selection circuit configured to select the ODT value based on the target die from among the plurality of ODT values, and an ODT circuit configured to provide the selected ODT value. Each memory die of the plurality of memory dies may further includes a storage circuit configured to store the plurality of ODT values.

### BRIEF DESCRIPTION OF DRAWINGS

Embodiments will be more clearly understood from the following detailed description taken in conjunction with the accompanying drawings in which:
FIG. 1 is a block diagram illustrating a storage device according to one or more embodiments;
FIG. 2 illustrates a non-volatile memory of FIG. 1;
FIG. 3 illustrates an on-die-termination (ODT) value table of the non-volatile memory of FIG. 2, according to one or more embodiments;
FIG. 4 is a flowchart illustrating an ODT control method of a non-volatile memory according to one or more embodiments;
FIG. 5 is a block diagram illustrating a non-volatile memory according to one or more embodiments;
FIG. 6 illustrates a non-volatile memory according to one or more embodiments;
FIG. 7 is a block diagram illustrating a storage device according to one or more embodiments;
FIG. 8 is a timing diagram showing a chip selection operation of a non-volatile memory of FIG. 7, according to one or more embodiments;
FIG. 9 is a block diagram illustrating a storage device according to one or more embodiments;
FIG. 10 is a timing diagram showing a chip selection operation of a non-volatile memory of FIG. 9, according to one or more embodiments;
FIG. 11 is a timing diagram showing an ODT control operation of the non-volatile memory of FIG. 9, according to one or more embodiments;
FIG. 12 is a block diagram illustrating a memory die according to one or more embodiments;
FIG. 13 is a block diagram illustrating a memory die according to one or more embodiments;
FIG. 14 illustrates a controller and a non-volatile memory, according to one or more embodiments;
FIG. 15A shows an ODT value table for a read operation of the non-volatile memory of FIG. 14, and FIG. 15B shows an ODT value table for a write operation of the non-volatile memory of FIG. 14;
FIG. 16A illustrates a read operation of a first die according to one or more embodiments, and FIG. 16B illustrates ODT values when the first die is a target die;
FIG. 17A illustrates a read operation of a second die according to one or more embodiments, and FIG. 17B illustrates ODT values when the second die is a target die;
FIG. 18A illustrates a read operation of a third die according to one or more embodiments, and FIG. 18B illustrates ODT values when the third die is a target die;
FIG. 19A illustrates a read operation of a fourth die according to one or more embodiments, and FIG. 19B illustrates ODT values when the fourth die is a target die;
FIG. 20A illustrates a write operation of a first die according to one or more embodiments, and FIG. 20B illustrates ODT values when the first die is a target die;
FIG. 21A illustrates a write operation of a fourth die according to one or more embodiments, and FIG. 21B illustrates ODT values when the fourth die is a target die;
FIG. 22 illustrates a controller and a non-volatile memory, according to one or more embodiments;
FIG. 23A shows an ODT value table for a read operation of the non-volatile memory of FIG. 22, and FIG. 23B shows an ODT value table for a write operation of the non-volatile memory of FIG. 22;
FIG. 24A illustrates a read operation of a first die according to one or more embodiments, and FIG. 24B illustrates ODT values when the first die is a target die;
FIG. 25A illustrates a read operation of a fourth die according to one or more embodiments, and FIG. 25B illustrates ODT values when the fourth die is a target die;
FIG. 26 illustrates a controller and a non-volatile memory, according to one or more embodiments;
FIG. 27A illustrates a read operation of a third die according to one or more embodiments, and FIG. 27B illustrates ODT values when the third die is a target die;
FIG. 28A illustrates a read operation of a seventh die according to one or more embodiments, and FIG. 28B illustrates ODT values when the seventh die is a target die;
FIG. 29 is a flowchart illustrating operation of a controller and a memory die, according to one or more embodiments;
FIG. 30 is a flowchart illustrating operation of a controller and a memory die, according to one or more embodiments;
FIG. 31 is a flowchart illustrating operation of a controller and a memory die, according to one or more embodiments;
FIG. 32 is a flowchart illustrating operation of a controller and a memory die, according to one or more embodiments;
FIG. 33A illustrates an equivalent circuit of an ODT resistor according to one or more embodiments, and FIG. 33B shows a timing diagram of a signal according to one or more embodiments; and
FIGS. 34, 35, 36, and 37 each illustrate a storage device according to one or more embodiments.

### DETAILED DESCRIPTION

Hereinafter, embodiments will be described in detail with reference to the accompanying drawings. Like reference numerals refer to like elements in the drawings, and their repeated descriptions are omitted. Embodiments described herein are example embodiments, and thus, the disclosure is not limited thereto.

It will be understood that, although the terms first, second, third, fourth, etc. may be used herein to describe various elements, components, regions, layers and/or sections (collectively "elements"), these elements should not be limited by these terms. These terms are only used to distinguish one element from another element. Thus, a first element described in this description section may be termed a second element or vice versa in the claim section without departing from the teachings of the disclosure.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

As used herein, an expression "at least one of" preceding a list of elements modifies the entire list of the elements and does not modify the individual elements of the list. For example, an expression, "at least one of a, b, and c" should be understood as including only a, only b, only c, both a and b, both a and c, both b and c, or all of a, b, and c.

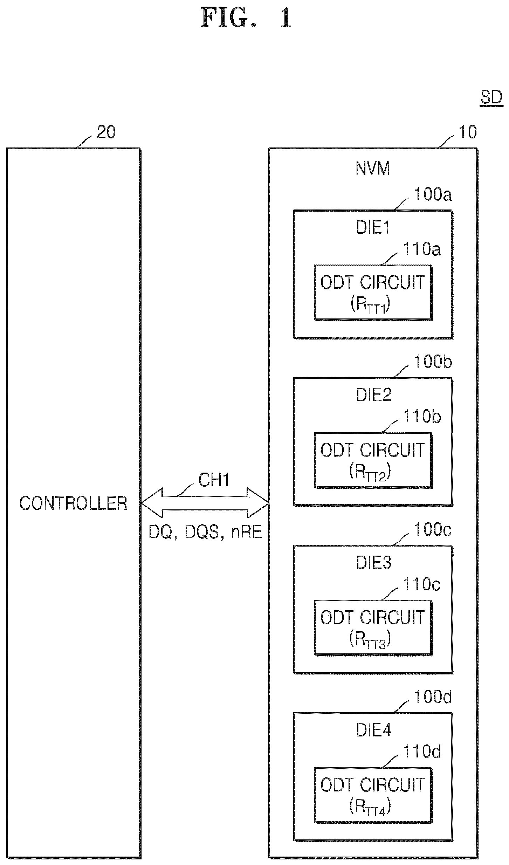

FIG. 1 is a block diagram illustrating a storage device SD according to one or more embodiments.

Referring to FIG. 1, the storage device SD may include a non-volatile memory 10 and a controller 20. The non-volatile memory 10 may include a plurality of memories configured to communicate with the controller 20 through a first channel CH1 and may be referred to as a memory package. For example, the plurality of memories may each be NAND flash memory, but embodiments are not limited thereto. The controller 20 may control the non-volatile memory 10, and thus, may be referred to as a memory controller or a non-volatile memory controller.

For example, the non-volatile memory 10 may include a plurality of memory dies, and thus, may be referred to as a multi-die memory. For example, the non-volatile memory 10 may include a plurality of memory chips, and thus, may be referred to as a multi-chip memory. For example, the plurality of memory dies may include a first die 100a, a second die 100b, a third die 100c, and a fourth die 100d, and thus, the non-volatile memory 10 may be a quadruple die package (QDP), but embodiments are not limited thereto.

The non-volatile memory 10 and the controller 20 may communicate with each other through the first channel CH1, and a data signal DQ, a data strobe signal DQS, and a read enable signal nRE may be transferred through the first channel CH1. In this case, the data strobe signal DQS and the read enable signal nRE may toggle at a relatively high-speed frequency, and the data signal DQ may be transferred in synchronization with the data strobe signal DQS and may thus be transferred at a relatively high speed. Therefore, the data signal DQ, the data strobe signal DQS, or the read enable signal nRE may be reflected from unselected dies of the first to fourth dies 100a to 100d connected to the first channel CH1, and thus, the signal integrity of the data signal DQ, the data strobe signal DQS, or the read enable signal nRE may be reduced.

Herein, a memory die selected by the controller 20 may be referred to as a target die, and a memory die which is not selected by the controller 20 may be referred to as a non-target die. A target die may be referred to as an operating die, an active die, or a selected die. A non-target die may be referred to as a standby die or an unselected die. In a case where the non-volatile memory 10 includes a plurality of memory dies, when a target is selected by the controller 20, the number of non-target dies may be greater than or equal to 2. In this case, a non-target die may be a source of a reflected wave, and source positions of reflected waves respectively corresponding to a plurality of non-target dies may differ, and thus, amplitudes and delays of reflected waves may differ.

According to one or more embodiments, each of the first to fourth dies 100a to 100d may include an on-die-termination (ODT) circuit which provides an ODT resistance based on a position of a target die, and thus, the reflection of the data signal DQ, the data strobe signal DQS, or the read enable signal nRE transferred at a relatively high speed may be more effectively prevented. For example, each of the first to fourth dies 100a to 100d may recognize an operating die or a target die and may provide an ODT resistance having an ODT value selected based on a target die from among a plurality of ODT values which are predefined. Accordingly, ODT resistances of a plurality of non-target dies may have different ODT values.

For example, the first die 100a may include a first ODT circuit 110a which includes a first ODT resistor R_{TT1}, the second die 100b may include a second ODT circuit 110b which includes a second ODT resistor R_{TT2}, the third die 100c may include a third ODT circuit 110c which includes a third ODT resistor R_{TT3}, and the fourth die 100d may include a fourth ODT circuit 110d which includes a fourth ODT resistor R_{TT4}. In this case, the first to fourth ODT resistors R_{TT1} to R_{TT4} may have different resistance values, based on the target die.

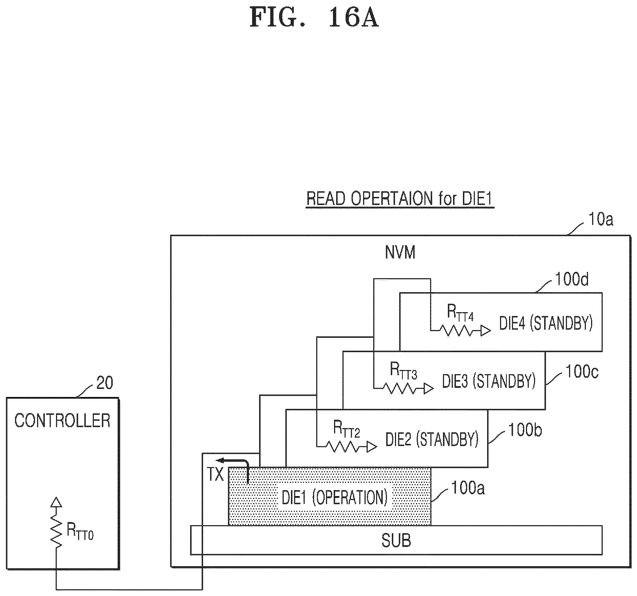

In one or more embodiments, the first to fourth ODT resistors R_{TT1} to R_{TT4} may have different resistance values, based on a position of the target die or a distance to the target die. For example, a distance may include a physical distance or an electrical distance. For example, when the first die 100a is a target die, the second ODT resistor R_{TT2} of the second die 100b and the fourth ODT resistor R_{TT4} of the fourth die 100d may have different resistance values. For example, as a physical distance or an electrical distance to a target die decreases, the delay of a reflected wave may decrease, and an amplitude of the reflected wave may increase. Thus, an ODT resistance value may be determined to be relatively large. For example, as a physical distance or an electrical distance to a target die increases, the delay of a reflected wave may increase, and an amplitude of the reflected wave may decrease, and thus, an ODT resistance value may be determined to be small. This will be described in more detail with reference to FIGS. 16A to 20B.

In one or more embodiments, the first to fourth ODT resistors R_{TT1} to R_{TT4} may have different resistance values, based on an operation of a target die (for example, a write operation or a read operation). For example, the second ODT resistor R_{TT2} of the second die 100b of when a write operation is performed on the first die 100a and the second ODT resistor R_{TT2} of the second die 100b of when a read operation is performed on the first die 100a may have different resistance values. This will be described in more detail with reference to FIGS. 16A to 22B.

In one or more embodiments, the first to fourth ODT resistors R_{TT1} to R_{TT4} may have different resistance values, based on channel topology. For example, the channel topology may correspond to topology of signal lines connected to the first channel CH1 in the non-volatile memory 10. The channel topology may be changed based on the placement of the first to fourth dies 100a to 100d in the non-volatile memory 10. For example, the first to fourth ODT resistors R_{TT1} to R_{TT4} in a case where the first to fourth dies 100a to 100d are stacked in a vertical direction may differ from the first to fourth ODT resistors R_{TT1} to R_{TT4} in a case where the first to fourth dies 100a to 100d are disposed in a horizontal direction. This will be described in more detail with reference to FIGS. 16A to 28B.

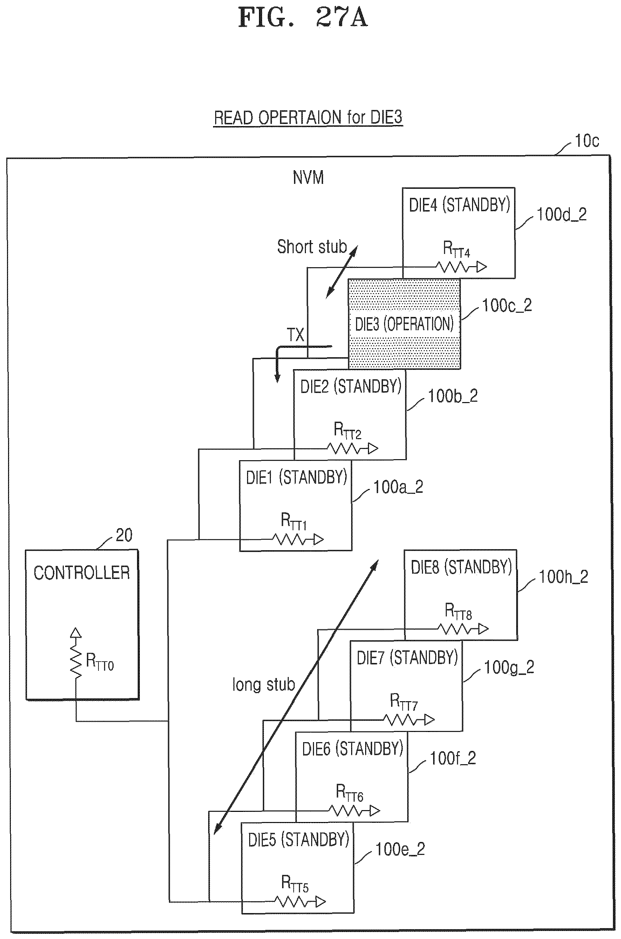

In one or more embodiments, the first to fourth ODT resistors R_{TT1} to R_{TT4} may have different resistance values, based on a length of a stub. Here, the stub may correspond to a line between a branch point and an endpoint in a channel. For example, the stub may be a branch line connected to a transfer line in parallel between a target die and a controller. For example, as a length of the stub decreases, the delay of a reflected wave may decrease, and an amplitude of the reflected wave may increase. Thus, an ODT resistance value may be determined to be relatively large. For example, as a length of the stub increases, the delay of a reflected wave may increase, and an amplitude of the reflected wave may decrease. Thus, an ODT resistance value may be determined to be relatively small. This will be described in more detail with reference to FIGS. 27A to 28B.

In one or more embodiments, ODT resistance values of first to fourth ODT resistors R_{TT1} to R_{TT4} may be selected based on a predefined ODT value table, so as to enhance signal integrity and decrease power consumption. For example, when a target die is a lower memory die, ODT values of upper memory dies may be set to be relatively small, and when the target die is an upper memory die, ODT values of lower memory dies may be set to be relatively large, thereby enhancing signal integrity and decreasing power consumption.

In one or more embodiments, the non-volatile memory 10 may include memory dies having complicated channel topology in a tree form, and in this case, an ODT resistance value of a stub connected to a number of memory dies may be set to be relatively small, and an ODT resistance value of a stub connected to few memory dies may be set to be relatively large. As a capacitance increases in a region where memory dies are densified, the impedance drop of a corresponding region in a high frequency domain may be large, and thus, an ODT resistance value in the corresponding region may be set to be small. As described above, an ODT resistance value may be variously selected based on the placement of memory dies included in the non-volatile memory 10.

In one or more embodiments, the storage device SD may be an internal memory which is embedded in an electronic device. For example, the storage device SD may be a solid state drive (SSD), an embedded universal flash storage (UFS) memory device, or an embedded multi-media card (eMMC). In some embodiments, the storage device SD may be an external memory which is attachable/detachable to/from an electronic device. For example, the storage device SD may be a UFS memory card, a compact flash (CF) card, a secure digital (SD) card, a micro secure digital (Micro-SD) card, a mini secure digital (Mini-SD) card, an extreme digital (xD) card, or a memory stick.

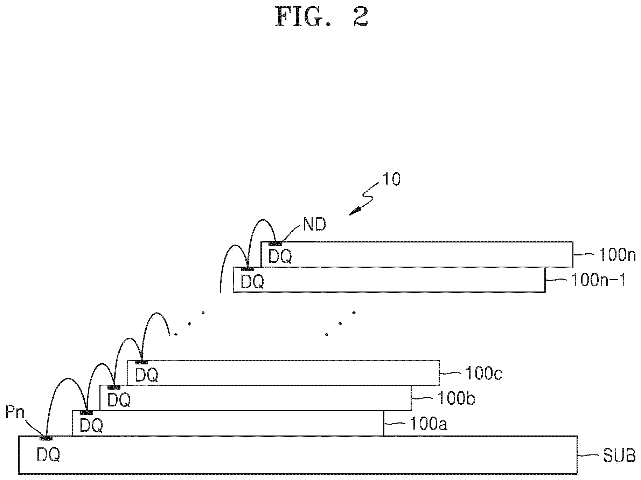

FIG. 2 illustrates the non-volatile memory 10 of FIG. 1.

Referring to FIG. 2, the non-volatile memory 10 may include a substrate SUB and first to n^{th} dies 100a to 100n (where n may be a positive integer). The first to n^{th} dies 100a to 100n may be vertically stacked on the substrate SUB. An input/output (I/O) pin Pn may be disposed on the substrate SUB, and I/O nodes ND of the first to n^{th} dies 100a to 100n may be connected to the I/O pin Pn. For example, the I/O pin Pn and the I/O nodes ND may be connected to each other through wire bonding, and in this case, the first to n^{th} dies 100a to 100n may be stacked in a horizontal direction with skew. However, embodiments are not limited thereto, and the first to n^{th} dies 100a to 100n may be connected to each other through a through via.

For example, when the first die 100a is selected, a target die may be the first die 100a, and a non-target die may be the second to n^{th} dies 100b to 100n. In a case where a read operation on the first die 100a is performed, data output from the first die 100a may be transferred to the controller 20 through the I/O pin Pn. A physical distance or an electrical distance between the first die 100a and the second die 100b may be relatively short, and a physical distance or an electrical distance between the first die 100a and the n^{th} die 100n may be relatively long. As described above, when the non-volatile memory 10 includes a plurality of non-target dies, the plurality of non-target dies may have different physical distances or electrical distances to the target die, and thus, amplitudes and delays of signals reflected from the plurality of non-target dies may differ. According to one or more embodiments, the plurality of non-target dies may provide different ODT resistances, based on the physical distances or electrical distances to the target die or a position of the target die.

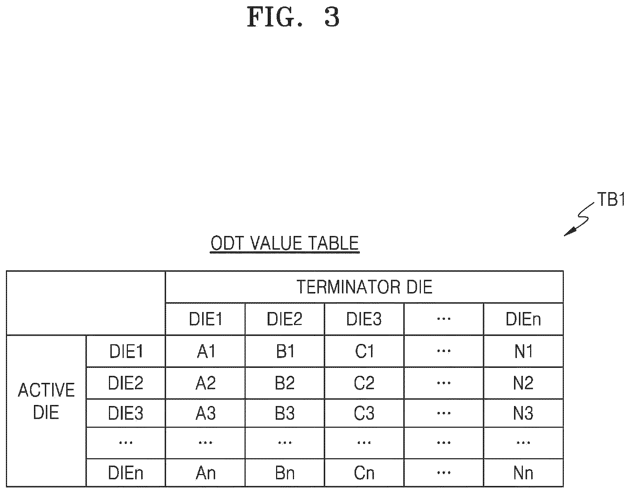

FIG. 3 illustrates an ODT value table TB1 of the non-volatile memory 10 of FIG. 2, according to one or more embodiments.

Referring to FIGS. 1 and 3, an active die may be a target die selected by the controller 20, and a terminator die may be a die which provides an ODT resistance or ODT resistance value. The ODT value table TB1 may store ODT values respectively corresponding to a plurality of dies. For example, the ODT value table TB1 may store the ODT values which are based on the active die and respectively correspond to the plurality of dies. A first die DIE1 may include an ODT resistance having one of A1 to An, based on the active die. For example, A1 to An may differ. Also, an n^{th} die DIEn may provide an ODT resistance having one of N1 to Nn, based on the active die. For example, N1 to Nn may differ.

For example, when the active die is the first die DIE1, the first die DIE1 may provide an ODT resistance having an ODT value 'A1', the second die DIE2 may provide an ODT resistance having an ODT value 'B1', the third die DIE3 may provide an ODT resistance having an ODT value 'C1', and the n^{th} die DIEn may provide an ODT resistance having an ODT value 'N1'. For example, B1, C1, and N1 may not be equal to one another. For example, at least one of B1, C1, and N1 may differ.

The non-volatile memory 10 may previously store the ODT value table TB1. For example, the ODT value table TB1 may be stored in a partial region of a memory cell array of the non-volatile memory 10. For example, the ODT value table TB1 may be stored in a static random access memory (RAM) (SRAM) or a register in a control logic of the non-volatile memory 10. When a chip selection signal is received from the controller 20, the non-volatile memory 10 may recognize a target die and may select an ODT value based on the target die from among the plurality of ODT values stored in the ODT value table TB1.

In one or more embodiments, when the controller 20 is powered up, the controller 20 may transfer information about the ODT value table TB1 to the non-volatile memory 10. For example, when the controller 20 is powered up, the controller 20 may transfer the plurality of ODT values to the non-volatile memory 10. In one or more embodiments, when the controller 20 is operating, the controller 20 may transfer update information about the ODT value table TB1 to the non-volatile memory 10. For example, when the controller 20 is operating, the controller 20 may transfer changed ODT values to the non-volatile memory 10.

In one or more embodiments, the plurality of ODT values included in the ODT value table TB1 may be designated as a silicon preset in a packaging operation of the non-volatile memory 10. In one or more embodiments, the plurality of ODT values included in the ODT value table TB1 may be designated by using eFuse or a partial region of a memory cell array in the packaging operation of the non-volatile memory 10. For example, the plurality of ODT values may be set based on evaluation data of the non-volatile memory 10, and in a package manufacturing process, the set plurality of ODT values may be stored in the non-volatile memory 10.

As described above, the first to n^{th} dies 100a to 100n of the non-volatile memory 10 may previously store optimal ODT value combination information about all dies before transferring or receiving an address, a command, or a data signal based on a memory operation such as a write/read operation. Also, each of the first to n^{th} dies 100a to 100n may check a current operation die and may select an ODT value matching each operation die. Accordingly, the controller 20 may not transfer a command or data for setting ODT values of non-target dies for each operation, and thus, I/O efficiency between the non-volatile memory 10 and the controller 20 may be largely enhanced. Also, the controller 20 may not transfer a command or data for newly setting ODT values of non-target dies whenever an operation die is changed, and thus, I/O efficiency between the non-volatile memory 10 and the controller 20 may be largely enhanced.

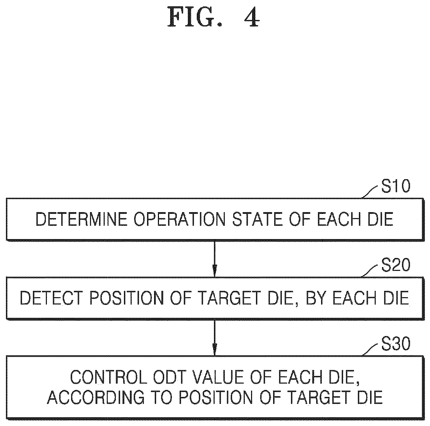

FIG. 4 is a flowchart illustrating an ODT control method of a non-volatile memory according to one or more embodiments.

Referring to FIG. 4, the ODT control method of the non-volatile memory may be a method which controls an ODT resistance, based on a position of a target die of a plurality of dies, and for example, may be performed in the non-volatile memory 10 of FIG. 1. Hereinafter, the ODT control method of the non-volatile memory will be described with reference to FIGS. 1 and 4.

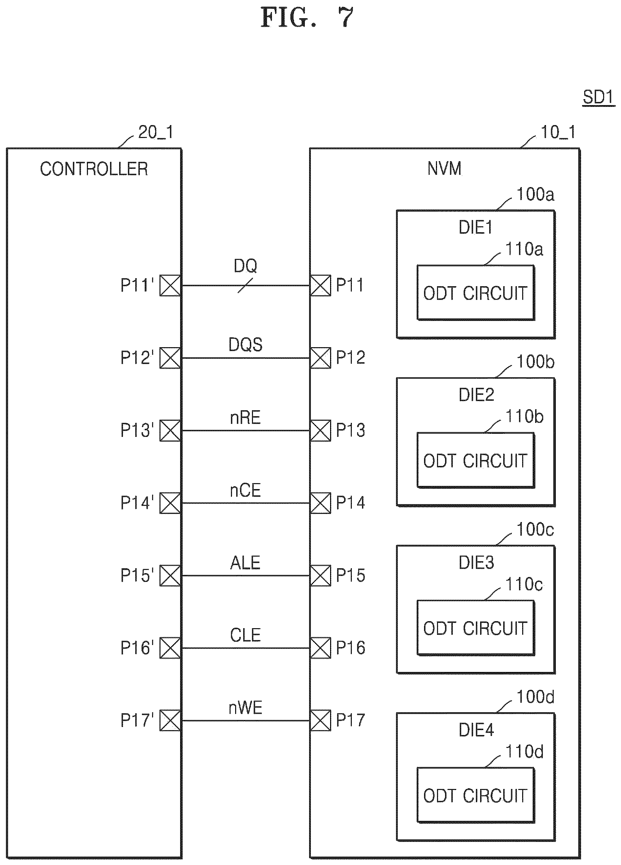

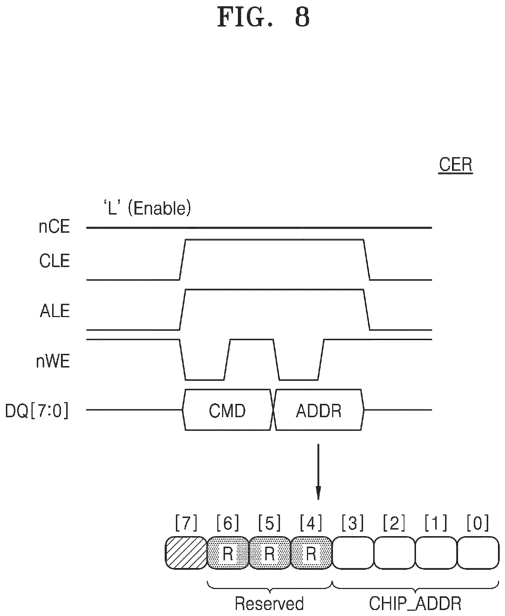

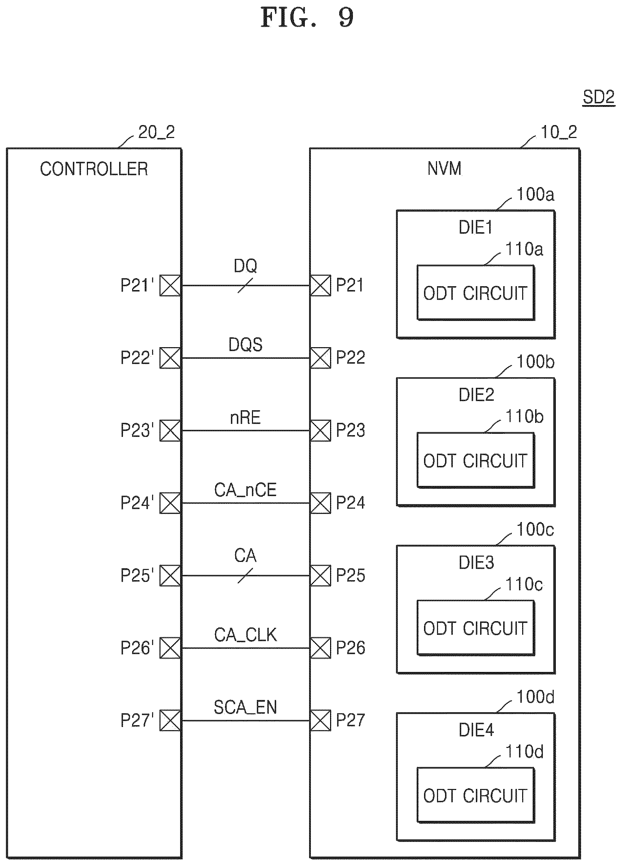

In operation S10, an operation state of each die may be determined. For example, the first to fourth dies 100a to 100d may determine whether each die is a target die or a non-target die, based on a chip selection signal received from the controller 20. For example, the chip selection signal may include a chip enable signal and an address received through an I/O pin, and this will be described below with reference to FIGS. 7 and 8. For example, the chip selection signal may include the chip enable signal and a command/address received through a command/address pin, and this will be described below with reference to FIGS. 9 to 11.

In operation S20, each die may detect a position of the target die. For example, the first to fourth dies 100a to 100d may detect a position of a target die of the first to fourth dies 100a to 100d, based on the chip selection signal received from the controller 20. In operation S30, an ODT value of each die may be controlled based on the position of the target die. For example, the first to fourth dies 100a to 100d may select an ODT value based on the target die, based on an ODT value table (for example, TB1 of FIG. 3), and may control an ODT resistance, based on the selected ODT value.

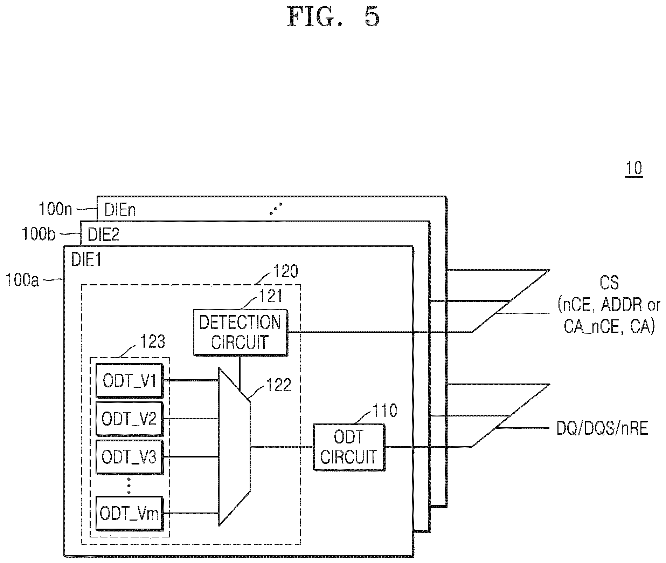

FIG. 5 is a block diagram illustrating a non-volatile memory 10 according to one or more embodiments.

Referring to FIG. 5, each of dies (for example, first to n^{th} dies) 100a to 100n included in the non-volatile memory 10 may include an ODT circuit 110 and an ODT control circuit 120. The ODT control circuit 120 may select an ODT value, based on a position of a target die, and the ODT circuit 110 may provide an ODT resistance having the ODT value selected by the ODT control circuit 120. For example, the ODT circuit 110 may be connected to an I/O pin which transfers or receives data DQ, a data strobe pin which transfers or receives a data strobe signal DQS, or a read enable pin which receives a read enable signal nRE.

The ODT control circuit 120 may include a detection circuit 121, a selection circuit 122, and a storage circuit 123. The storage circuit 123 may store a plurality of ODT values corresponding to each die, and for example, may store a plurality of ODT values ODT_V1 to ODT_Vm (where m may be a positive integer) corresponding to the first die 100a. For example, the storage circuit 123 may be implemented as a partial region of a memory cell array. As another example, the storage circuit 123 may be implemented as SRAM or a register.

In one or more embodiments, when the non-volatile memory 10 is powered up, the non-volatile memory 10 may receive a plurality of ODT values from the controller 20 and may store the received plurality of ODT values in the storage circuit 123. For example, the controller 20 may transfer ODT values to the non-volatile memory 10, based on a command. In one or more embodiments, when the non-volatile memory 10 is operating, the non-volatile memory 10 may further receive changed ODT values from the controller 20 and may update (store) the changed ODT values in the storage circuit 123. For example, the controller 20 may transfer the changed ODT values to the non-volatile memory 10, based on a command. In one or more embodiments, the non-volatile memory 10 may update a plurality of ODT values in the storage circuit 123, based on a training operation (for example, a result of ZQ training).

The detection circuit 121 may detect an operation state of a corresponding die and a position of a target die, based on a chip selection signal CS received from the controller 20. For example, the chip selection signal CS may include a chip enable signal nCE and an address ADDR, and this will be described below with reference to FIGS. 7 and 8. For example, the chip selection signal CS may include a command/address chip enable signal CA_nCE and a command/address CA, and this will be described below with reference to FIGS. 9 to 11.

The detection circuit 121 may generate a selection signal corresponding to an ODT value selected from among the plurality of ODT values ODT_V1 to ODT_Vm, based on the detected position of the target die. The selection circuit 122 may select one ODT value from among the plurality of ODT values ODT_V1 to ODT_Vm, based on the selection signal. For example, the selection circuit 122 may be implemented as a multiplexer. The ODT circuit 110 may provide an ODT resistance having the selected ODT value.

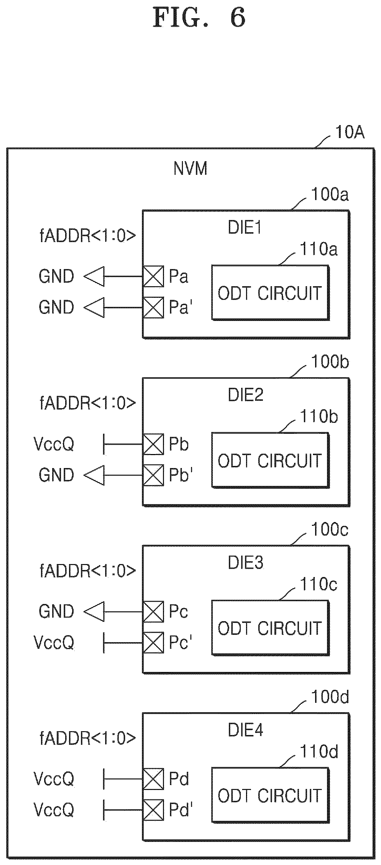

FIG. 6 illustrates a non-volatile memory 10A according to one or more embodiments.

Referring to FIG. 6, the non-volatile memory 10A may include a first die 100a, a second die 100b, a third die 100c, and a fourth die 100d, and the first to fourth dies 100a to 100d may each include an address pin corresponding to a die address fADDR<1:0>. For example, the die address fADDR<1:0> may be a 2-bit signal and may indicate four dies. In some embodiments, the non-volatile memory 10A may include first to sixteenth dies, and in this case, may indicate the first to sixteenth dies by using a die address fADDR<3:0> of a 4-bit signal.

For example, the die address fADDR<1:0> may be designated as a silicon preset in a packaging operation of the non-volatile memory 10A. For example, the die address fADDR<1:0> may be designated by using eFuse in the packaging operation of the non-volatile memory 10A. The first die 100a may include address pins Pa and Pa' to which a ground voltage GND is applied. The second die 100b may include address pins Pb and Pb' to which a power supply voltage VccQ and the ground voltage GND are respectively applied. The third die 100c may include address pins Pc and Pc' to which the ground voltage GND and the power supply voltage VccQ are respectively applied. The fourth die 100d may include address pins Pd and Pd' to which the power supply voltage VccQ is applied.

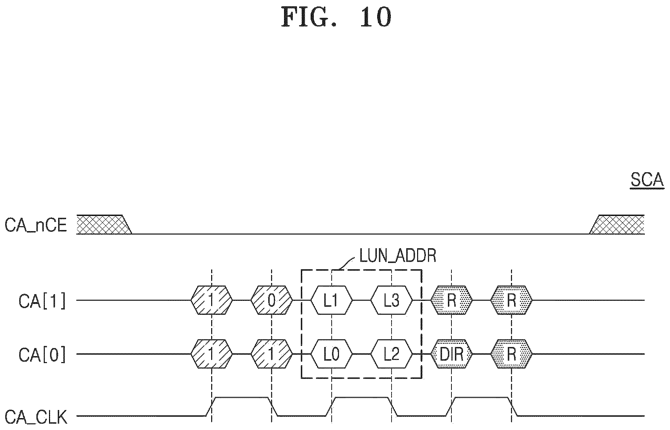

The first to fourth dies 100a to 100d may compare the die address fADDR<1:0> with a chip address (for example, CHIP_ADDR of FIG. 8) or a logical unit number (LUN) address (for example, LUN_ADDR of FIG. 10) included in a chip selection signal (for example, CS of FIG. 5) received from a controller (for example, 20 of FIG. 1) and may determine an operation state of each die, based on a comparison result. For example, when the chip address or the LUN address is the same as the die address fADDR<1:0>, a corresponding die may be determined to be a target die. For example, when the chip address or the LUN address is not equal to the die address fADDR<1:0>, the corresponding die may be determined to be a non-target die.

FIG. 7 is a block diagram illustrating a storage device SD1 according to one or more embodiments.

Referring to FIG. 7, the storage device SD1 may include a non-volatile memory 10_1 and a controller 20_1. The non-volatile memory 10_1 may correspond to an implementation example of the non-volatile memory 10 of FIG. 1 and may further include a plurality of pins P11 to P17 compared to the non-volatile memory 10. The controller 20_1 may correspond to an implementation example of the controller 20 of FIG. 1 and may further include a plurality of pins P11' to P17' compared to the controller 20.

The non-volatile memory 10_1 may transfer or receive a data signal DQ to or from the controller 20_1 through a plurality of pins P11, and thus, the plurality of pins P11 may be referred to as a plurality of I/O pins. In this case, the data signal DQ may include a command, an address, and data. The non-volatile memory 10_1 may transfer or receive a data strobe signal DQS to or from the controller 20_1 through the pin P12, and thus, the pin P12 may be referred to as a data strobe pin. The non-volatile memory 10_1 may receive a read enable signal nRE from the controller 20_1 through the pin P13, and thus, the pin P13 may be referred to as a read enable pin.

Also, the non-volatile memory 10_1 may receive a chip enable signal nCE from the controller 20_1 through the pin P14, and thus, the pin P14 may be referred to as a chip enable pin. The non-volatile memory 10_1 may receive an address latch enable signal ALE from the controller 20_1 through the pin P15, and thus, the pin P15 may be referred to as an address latch enable pin. The non-volatile memory 10_1 may receive a command latch enable signal CLE from the controller 20_1 through the pin P16, and thus, the pin P16 may be referred to as a command latch enable pin P16. The non-volatile memory 10_1 may receive a write enable signal nWE from the controller 20_1 through the pin P17, and thus, the pin P17 may be referred to as a write enable pin.

The controller 20_1 may include the plurality of pins P11' to P17' respectively connected to the plurality of pins P11 to P17 of the non-volatile memory 10_1. As described above, the non-volatile memory 10_1 may communicate with the controller 20_1 through the plurality of pins P11 to P17, and the data signal DQ, the data strobe signal DQS, the read enable signal nRE, the chip enable signal nCE, the address latch enable signal ALE, the command latch enable signal CLE, and the write enable signal nWE may configure the first channel CH1 of FIG. 1.

FIG. 8 is a timing diagram showing a chip selection operation of the non-volatile memory 10_1 of FIG. 7, according to one or more embodiments.

Referring to FIGS. 7 and 8, the chip selection operation according to one or more embodiments may be an operation of selecting a target die from among a plurality of dies, based on the chip enable signal nCE and the data signal DQ, and may be performed through a chip enable reduction (CER) method. In a period where the chip enable signal nCE has an enable level (for example, a logic low level) and the command latch enable signal CLE and the address latch enable signal ALE have an enable level (for example, a logic high level), the non-volatile memory 10_1 may receive a command CMD and an address ADDR, based on a data signal DQ[7:0] received through a plurality of I/O pins (i.e., a plurality of pins P11). For example, the command CMD may be E1h, and the command CMD and the address ADDR may be transferred as a command set.

For example, some bits of the address ADDR may include a chip address CHIP_ADDR, and the non-volatile memory 10_1 may determine a target die and non-target dies of a plurality of dies, based on the chip address CHIP_ADDR. For example, each of first to fourth dies 100a to 100d may receive the chip address CHIP_ADDR, determine an operation state of each of the first to fourth dies 100a to 100d, based on the chip address CHIP_ADDR, and detect a position of the target die.

FIG. 9 is a block diagram illustrating a storage device SD2 according to one or more embodiments.

Referring to FIG. 9, the storage device SD2 may include a non-volatile memory 10_2 and a controller 20_2, and the non-volatile memory 10_2 and the controller 20_2 may communicate with each other, based on a separate command address (SCA) scheme where a command/address CA is transferred separately of data DQ. The non-volatile memory 10_2 may correspond to an implementation example of the non-volatile memory 10 of FIG. 1 and may further include a plurality of pins P21 to P27 compared to the non-volatile memory 10. The controller 20_2 may correspond to an implementation example of the controller 20 of FIG. 1 and may further include a plurality of pins P21' to P27' compared to the controller 20.

The non-volatile memory 10_2 may transfer or receive data DQ to or from the controller 20_2 through a plurality of pins P21, and thus, the plurality of pins P21 may be referred to as a plurality of I/O pins or a plurality of data pins. The non-volatile memory 10_2 may transfer or receive a data strobe signal DQS to or from the controller 20_2 through the pin P22, and thus, the pin P22 may be referred to as a data strobe pin. The non-volatile memory 10_2 may receive a read enable signal nRE from the controller 20_2 through the pin P23, and thus, the pin P23 may be referred to as a read enable pin.

Also, the non-volatile memory 10_2 may receive a command/address chip enable signal CA_nCE from the controller 20_2 through the pin P24, and thus, the pin P24 may be referred to as a chip enable pin. The non-volatile memory 10_2 may receive a command/address CA from the controller 20_2 through a plurality of pins P25, and thus, the plurality of pins P25 may be referred to as command/address pins. The non-volatile memory 10_2 may receive a command/address clock CA_CLK from the controller 20_2 through the pin P26, and thus, the pin P26 may be referred to as a command/address clock pin. The non-volatile memory 10_2 may receive an SCA enable signal SCA_EN from the controller 20_2 through the pin P27, and thus, the pin P27 may be referred to as an SCA enable pin.

The controller 20_2 may include the plurality of pins P21' to P27' respectively connected to the plurality of pins P21 to P27 of the non-volatile memory 10_2. As described above, the non-volatile memory 10_2 may communicate with the controller 20_2 through the plurality of pins P21 to P27, and the data signal DQ, the data strobe signal DQS, the read enable signal nRE, the command/address chip enable signal CA_nCE, the command/address CA, the command/address clock CA_CLK, and the SCA enable signal SCA_EN may configure the first channel CH1 of FIG. 1.

FIG. 10 is a timing diagram showing a chip enable operation of the non-volatile memory 10_2 of FIG. 9, according to one or more embodiments.

Referring to FIGS. 9 and 10, the chip enable operation according to one or more embodiments may be an operation of selecting a target die from among a plurality of dies, based on the command/address chip enable signal CA_nCE and the command/address CA, and may be performed through an SCA method. In a period where the command/address chip enable signal CA_nCE has an enable level (for example, a low logic level), the non-volatile memory 10_2 may receive a command/address CA<1:0> through command/address pins P25. The controller 20_2 may transfer the command/address CA<1:0> in synchronization with a rising edge and a falling edge of the command/address clock CA_CLK. For example, a select chip enable (SCE) packet may be transferred during 3 clock cycles of the command/address clock CA_CLK.

For example, the command/address CA<1:0> may include an LUN address LUN_ADDR representing an active LUN. For example, the LUN address LUN_ADDR may be transferred as a portion of the SCE packet. Here, an LUN may be a minimum unit for independently executing a command, and for example, may correspond to a memory die. The non-volatile memory 10_2 may determine a target die and non-target dies of a plurality of dies, based on the LUN address LUN_ADDR. For example, each of first to fourth dies 100a to 100d may receive the LUN address LUN_ADDR, determine an operation state of each of the first to fourth dies 100a to 100d, based on the LUN address LUN_ADDR, and detect a position of the target die.

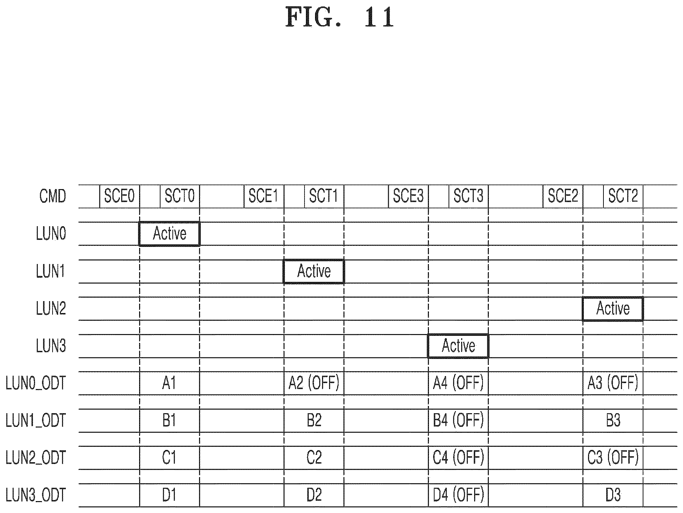

FIG. 11 is a timing diagram showing an ODT control operation of the non-volatile memory 10_2 of FIG. 9, according to one or more embodiments.

Referring to FIG. 11, the non-volatile memory 10_2 may receive a select chip enable signal SCE0, which activates LUN0, from the controller 20_2 through command/address pins P25, and then, may receive a select chip terminate SCT0 which ends LUN0. For example, as illustrated in FIG. 10, the select chip enable signal SCE0 may be transferred in the form of packets. In response to the select chip enable signal SCE0, a first die 100a corresponding to LUN0 may be selected, and second to fourth dies 100b to 100d respectively corresponding to LUN1 to LUN3 may not be selected. In this case, based on the ODT value table TB1 illustrated in FIG. 3, ODT values of the second to fourth dies 100b to 100d may be respectively determined to be B1, C1, and D1.

The non-volatile memory 10_2 may receive a select chip enable signal SCE1, which activates LUN1, from the controller 20_2 through the command/address pins P25, and then, may receive a select chip terminate SCT1 which ends LUN1. In response to the select chip enable signal SCE1, the second die 100b corresponding to LUN1 may be selected, and the first, third, and fourth dies 100a, 100c, and 100d respectively corresponding to LUN0, LUN2, and LUN3 may not be selected. In this case, based on the ODT value table TB1 illustrated in FIG. 3, ODT values of the first, third, and fourth dies 100a, 100c, and 100d may be respectively determined to be A2, C2, and D2. For example, A2 may be set to be infinite, and thus, a first ODT resistor R_{TT1} of the first die 100a may be turned off.

The non-volatile memory 10_2 may receive a select chip enable signal SCE3, which activates LUN3, from the controller 20_2 through the command/address pins P25, and then, may receive a select chip terminate SCT3 which ends LUN3. In response to the select chip enable signal SCE3, the fourth die 100d corresponding to LUN3 may be selected, and the first to third dies 100a to 100c respectively corresponding to LUN0 to LUN2 may not be selected. In this case, based on the ODT value table TB1 illustrated in FIG. 3, ODT values of the first to third dies 100a to 100c may be respectively determined to be A4, B4, and C4.

The non-volatile memory 10_2 may receive a select chip enable signal SCE2, which activates LUN2, from the controller 20_2 through the command/address pins P25, and then, may receive a select chip terminate SCT2 which ends LUN2. In response to the select chip enable signal SCE2, the third die 100c corresponding to LUN2 may be selected, and the first, second, and fourth dies 100a, 100b, and 100d respectively corresponding to LUN0, LUN1, and LUN3 may not be selected. In this case, based on the ODT value table TB1 illustrated in FIG. 3, ODT values of the first, second, and fourth dies 100a, 100b, and 100d may be respectively determined to be A3, B3, and C3.

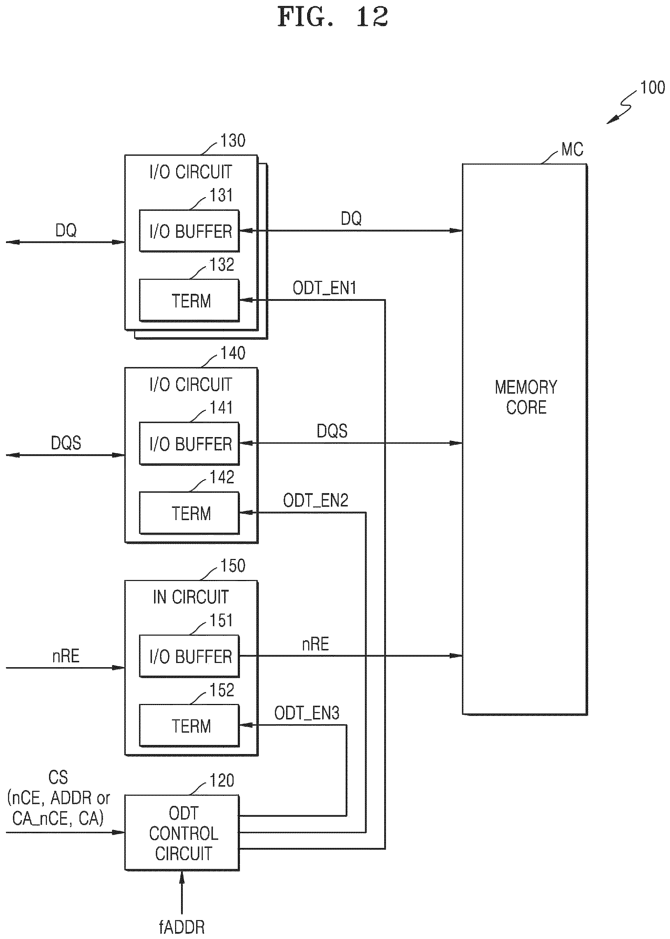

FIG. 12 is a block diagram illustrating a memory die 100 according to one or more embodiments.

Referring to FIG. 12, the memory die 100 may include an ODT control circuit 120, first I/O circuits 130, a second I/O circuit 140, an input circuit 150, and a memory core MC. The memory core MC may include a memory cell array, a row decoder, a page buffer, and a voltage generator and may be referred to as a data path circuit. For example, each of the first to fourth dies 100a to 100d of FIG. 1 may be implemented like the memory die 100. For example, each of the ODT circuits 110a to 110d of FIG. 1 may correspond to one of ODT circuits 132, 142, and 152.

The ODT control circuit 120 may detect a target die, based on a chip selection signal CS. In one or more embodiments, the ODT control circuit 120 may detect the target die, based on a chip enable signal nCE and an address ADDR. In one or more embodiments, the ODT control circuit 120 may detect the target die, based on a command/address chip enable signal CA_nCE and a command/address CA.

The ODT control circuit 120 may compare the chip selection signal CS with a die address fADDR to determine an operation state of each die. For example, when the chip selection signal CS corresponds to the die address fADDR, the ODT control circuit 120 may determine that the memory die 100 is the target die. When the chip selection signal CS does not correspond to the die address fADDR, the ODT control circuit 120 may determine that the memory die 100 is a non-target die.

The ODT control circuit 120 may select one ODT value from among a different plurality of ODT values, based on a relative distance to the target die. For example, the relative distance may include a relative physical distance or a relative electrical distance. For example, the ODT control circuit 120 may include a storage circuit which stores an ODT value table (for example, TB1 of FIG. 3) storing a plurality of ODT values. In one or more embodiments, the ODT control circuit 120 may generate an ODT selection signal ODT_EN1 corresponding to a data signal DQ, based on the target die. In one or more embodiments, the ODT control circuit 120 may generate an ODT selection signal ODT_EN2 corresponding to a data strobe signal DQS, based on the target die. In one or more embodiments, the ODT control circuit 120 may generate an ODT selection signal ODT_EN3 corresponding to a read enable signal nRE, based on the target die.

The first I/O circuits 130 may transfer or receive a plurality of data signals DQ<7:0>, and each of the first I/O circuits 130 may include an I/O buffer 131 and an ODT circuit 132. The I/O buffer 131 may output data to the memory core MC, or may receive the data from the memory core MC. The ODT circuit 132 may receive the ODT selection signal ODT_EN1 from the ODT control circuit 120 and may provide an ODT resistance having an ODT value based on the ODT selection signal ODT_EN1.

The second I/O circuit 140 may transfer or receive the data strobe signal DQS to or from the controller 20. The second I/O circuit 140 may include an I/O buffer 141 and an ODT circuit 142. The I/O buffer 141 may output the data strobe signal DQS to the memory core MC, or may receive the data strobe signal DQS from the memory core MC. The ODT circuit 142 may receive the ODT selection signal ODT_EN2 from the ODT control circuit 120 and may provide an ODT resistance having an ODT value based on the ODT selection signal ODT_EN2.

The input circuit 150 may receive the read enable signal nRE from the controller 20. The input circuit 150 may include an I/O buffer 151 and an ODT circuit 152. The I/O buffer 151 may output the read enable signal nRE to the memory core MC. The ODT circuit 152 may receive the ODT selection signal ODT_EN3 from the ODT control circuit 120 and may provide an ODT resistance having an ODT value based on the ODT selection signal ODT_EN3.

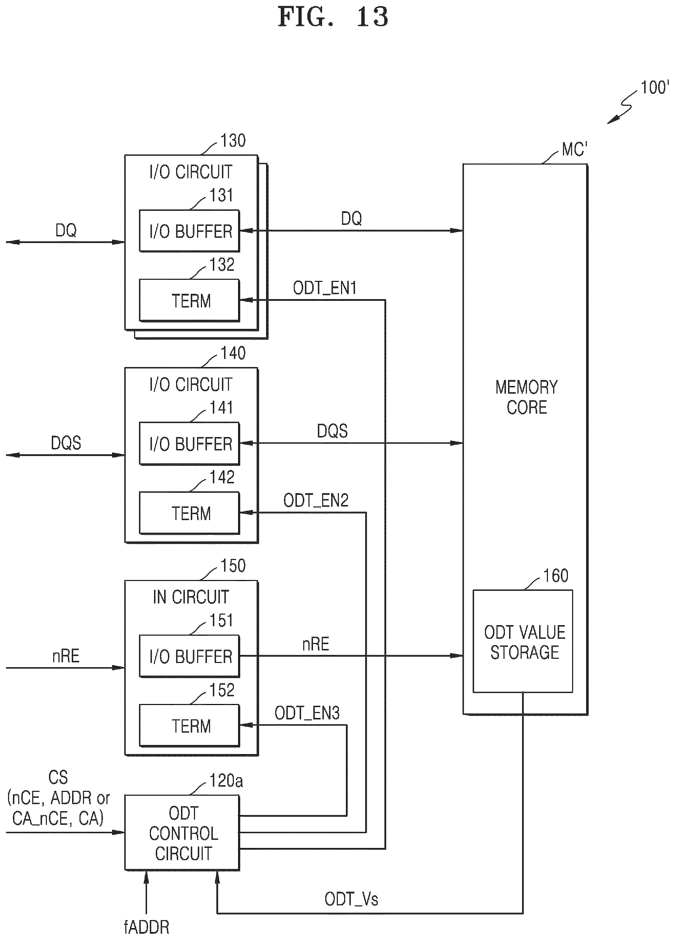

FIG. 13 is a block diagram illustrating a memory die 100' according to one or more embodiments.

Referring to FIG. 13, the memory die 100' may correspond to a modification example of the memory die 100 of FIG. 12. A memory core MC' of the memory die 100' may include an ODT value storage 160. For example, the ODT value storage 160 may correspond to a partial region of a memory cell array of the memory core MC'.

In one or more embodiments, before releasing a package, the memory die 100' may previously store ODT values in the ODT value storage 160, based on an optimal ODT value combination calculated (obtained) through an evaluation of the memory die 100'. In one or more embodiments, the memory die 100' may previously receive the ODT values from a controller and may store the received ODT values in the ODT value storage 160.

An ODT control circuit 120a may receive a plurality of ODT values ODT_Vs from the ODT value storage 160 and may select one ODT value from among the plurality of ODT values ODT_Vs, based on a chip selection signal CS and a die address fADDR. The ODT control circuit 120a may select ODT values which respectively correspond to an ODT circuit 132 corresponding to a data signal DQ, an ODT circuit 142 corresponding to a data strobe signal DQS, and an ODT circuit 152 corresponding to a read enable signal nRE.

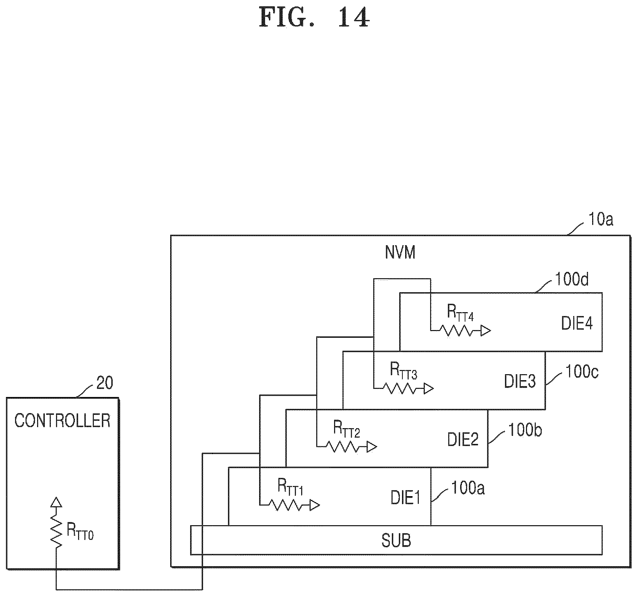

FIG. 14 illustrates a controller 20 and a non-volatile memory 10a according to one or more embodiments.

Referring to FIG. 14, the non-volatile memory 10a may include first to fourth dies 100a to 100d which are stacked on a substrate SUB. In a case where a signal is transferred between the controller 20 and the non-volatile memory 10a, the controller 20 may include an ODT resistor R_{TT0}, the first die 100a may include a first ODT resistor R_{TT1}, the second die 100b may include a second ODT resistor R_{TT2}, the third die 100c may include a third ODT resistor R_{TT3}, and the fourth die 100d may include a fourth ODT resistor R_{TT4}. In this case, the first to fourth ODT resistors R_{TT1} to R_{TT4} may have different ODT values, based on a target die.

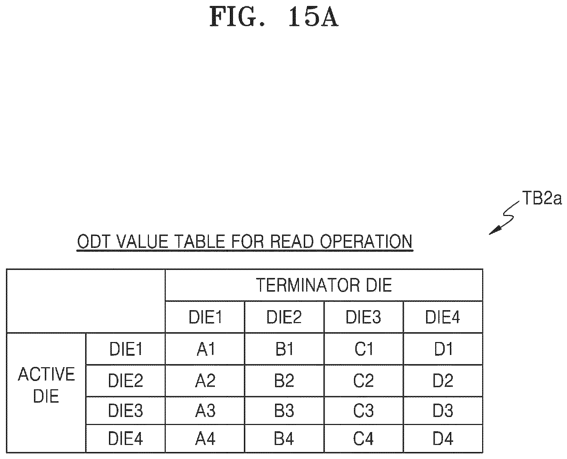

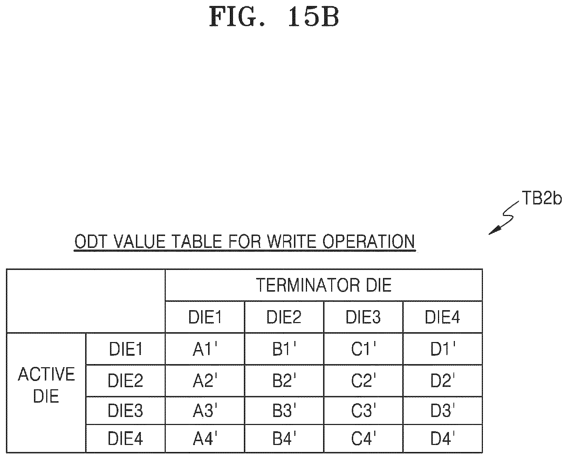

FIG. 15A shows an ODT value table TB2a for a read operation of the non-volatile memory of FIG. 14, and FIG. 15B shows an ODT value table TB2b for a write operation of the non-volatile memory of FIG. 14.

Referring to FIG. 15A in conjunction with FIG. 14, the ODT value table TB2a for read operation may show read ODT resistances of first to fourth dies 100a to 100d based on an active die, when performing a read operation on a non-volatile memory 10a. For example, a read ODT value of the first die 100a may be A2 when the active die is the second die 100b, may be A3 when the active die is the third die 100c, and may be A4 when the active die is the fourth die 100d, and A2, A3, and A4 may differ. For example, when the first die 100a is the active die, read ODT values of the second to fourth dies 100b to 100d may be B1, C1, and D1, and B1, C1, and D1 may differ.

Referring to FIG. 15B in conjunction with FIG. 14, the ODT value table TB2b for write operation may show write ODT resistances of first to fourth dies 100a to 100d based on an active die, when performing a write operation on the non-volatile memory 10a. For example, a write ODT value of the first die 100a may be A2' when the active die is the second die 100b, may be A3' when the active die is the third die 100c, and may be A4' when the active die is the fourth die 100d, and A2', A3', and A4' may differ. For example, when the first die 100a is the active die, write ODT values of the second to fourth dies 100b to 100d may be B1', C1', and D1', and B1', C1', and D1' may differ.

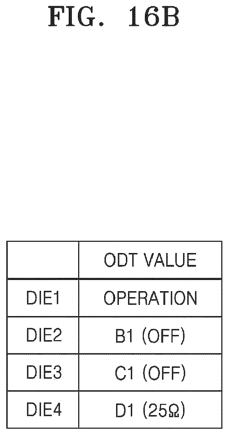

FIG. 16A illustrates a read operation of a first die 100a according to one or more embodiments, and FIG. 16B illustrates ODT values when the first die 100a is a target die.

Referring to FIGS. 16A and 16B, when performing a read operation on the first die 100a, a controller 20 may transfer a chip selection signal for selecting the first die 100a from among first to fourth dies 100a to 100d. The first die 100a may operate as a transmitter TX in response to the chip selection signal, and the first die 100a may transfer read data to a controller 20. In this case, an endpoint of a signal transferred from the first die 100a may be the controller 20 and a fourth die 100d, and thus, ODT may be applied at each of two endpoints. For example, read data or a data strobe signal output from the first die 100a or a read enable signal received from the controller 20 may be reflected from second to fourth dies 100b to 100d. According to one or more embodiments, each of the second to fourth dies 100b to 100d may provide an ODT resistance, and thus, a signal reflected from each of the second to fourth dies 100b to 100d may be reduced.

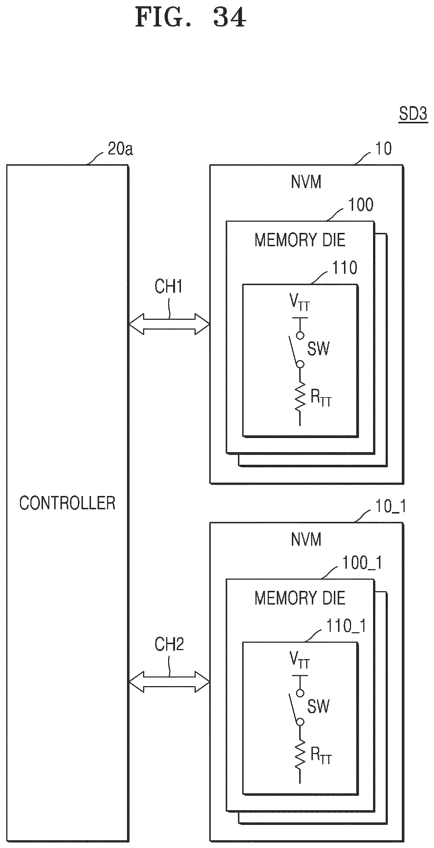

For example, because a physical distance or an electrical distance between the first die 100a and the second die 100b may be relatively short, a signal reflected from the second die 100b may be relatively short in delay and relatively large in amplitude. Therefore, an ODT value B1 of a second ODT resistor R_{TT2} of the second die 100b may be set to be infinite. Similarly, because a physical distance or an electrical distance between the first die 100a and the third die 100c is relatively short, an ODT value C1 of a third ODT resistor R_{TT3} of the third die 100c may be set to be infinite. Therefore, an ODT switch (for example, SW of FIG. 34) corresponding to each of the second and third ODT resistors R_{TT2} and R_{TT3} may be turned off, and each of the second and third ODT resistors R_{TT2} and R_{TT3} may not be connected to a source voltage terminal (for example, V_{TT} of FIG. 34).

For example, because a stub length between the first die 100a and the fourth die 100d may be relatively long and the fourth die 100d corresponds to an endpoint and is a point at which an impedance varies largely, a signal reflected from the fourth die 100d may be relatively long in delay and relatively large in amplitude. Accordingly, an ODT value D1 of a fourth ODT resistor R_{TT4} of the fourth die 100d may be set to a value (for example, 25 Ω) which is less than B1 and C1. As described above, when a lower memory die (i.e., the first die 100a) close to the substrate SUB is a target die, an upper memory die (i.e., the fourth die 100d) connected to a channel end may provide a certain ODT resistance, and ODT resistors of middle memory dies (i.e., the second and third dies 100b and 100c) may be turned off, thereby enhancing signal integrity and reducing power consumption.

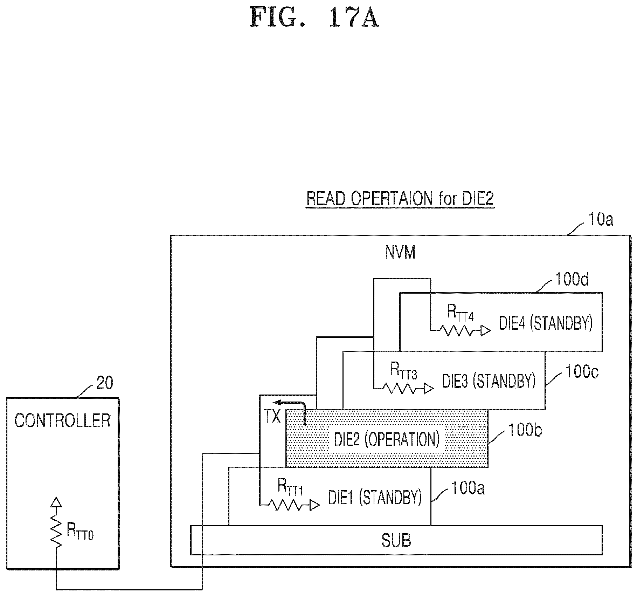

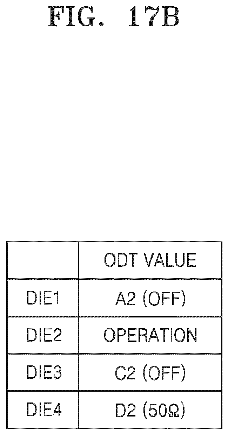

FIG. 17A illustrates a read operation of a second die 100b according to one or more embodiments, and FIG. 17B illustrates ODT values when the second die 100b is a target die.

Referring to FIGS. 17A and 17B, when performing a read operation on the second die 100b, the second die 100b may operate as a transmitter TX in response to a chip selection signal, and the second die 100b may transfer read data to a controller 20. At this time, read data or a data strobe signal output from the second die 100b or a read enable signal received from the controller 20 may be reflected from first, third, and fourth dies 100a, 100c, and 100d.

For example, because a physical distance or an electrical distance between the first die 100a and the second die 100b is relatively short, a signal reflected from the first die 100a may be relatively short in delay and relatively large in amplitude. Therefore, an ODT value A2 of a first ODT resistor R_{TT1} of the first die 100a may be set to be infinite. Similarly, because a physical distance or an electrical distance between the second die 100b and the third die 100c may be relatively short, an ODT value C2 of a third ODT resistor R_{TT3} of the third die 100c may be set to be infinite. For example, because a stub length between the second die 100b and the fourth die 100d may be relatively long and the fourth die 100d corresponds to an endpoint and is a point at which an impedance varies largely, a signal reflected from the fourth die 100d may be relatively long in delay and relatively large in amplitude. Accordingly, an ODT value D2 of a fourth ODT resistor R_{TT4} of the fourth die 100d may be set to a value (for example, 50 Ω) which is less than A2 and C2.

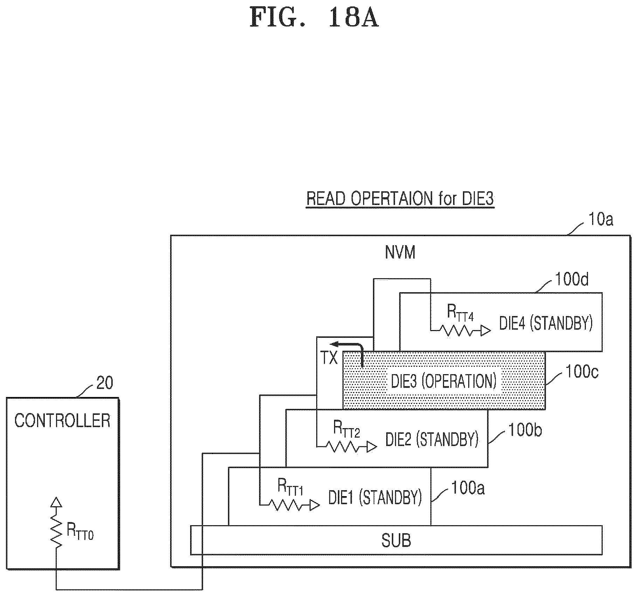

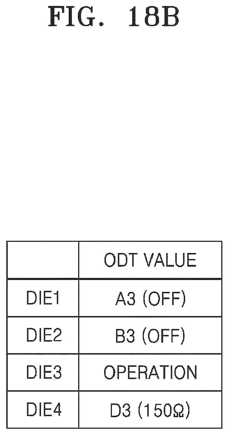

FIG. 18A illustrates a read operation of a third die 100c according to one or more embodiments, and FIG. 18B illustrates ODT values when the third die 100c is a target die.

Referring to FIGS. 18A and 18B, when performing a read operation on the third die 100c, the third die 100c may operate as a transmitter TX in response to a chip selection signal, and the third die 100c may transfer read data to a controller 20. At this time, read data or a data strobe signal output from the third die 100c or a read enable signal received from the controller 20 may be reflected from first, second, and fourth dies 100a, 100b, and 100d.

Therefore, an ODT value A3 of a first ODT resistor R_{TT1} of the first die 100a may be set to be infinite, and an ODT value B3 of a second ODT resistor R_{TT2} of the second die 100b may be set to be infinite. For example, a stub length between the third die 100c and the fourth die 100d may be shorter than a stub length between the second die 100b and the fourth die 100d, and thus, an ODT value D3 of a fourth ODT resistor R_{TT4} of the fourth die 100d may be set to a value (for example, 150 Ω) which is greater than D2. Accordingly, the signal integrity of the non-volatile memory 10a may be enhanced.

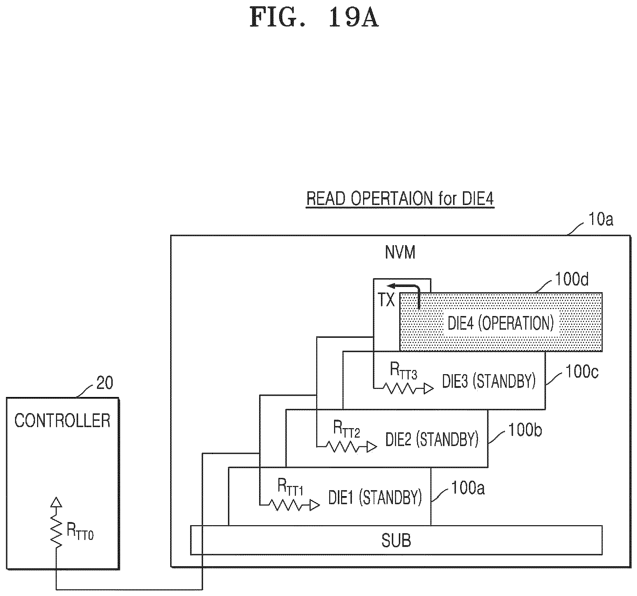

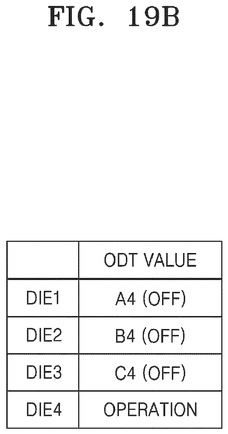

FIG. 19A illustrates a read operation of a fourth die 100d according to one or more embodiments, and FIG. 19B illustrates ODT values when the fourth die 100d is a target die.

Referring to FIGS. 19A and 19B, when performing a read operation on the fourth die 100d, the fourth die 100d may operate as a transmitter TX in response to a chip selection signal, and the fourth die 100d may transfer read data to a controller 20. At this time, read data or a data strobe signal output from the fourth die 100d or a read enable signal received from the controller 20 may be reflected from first to third dies 100a to 100c.

The fourth die 100d which is a target die may be connected to a channel end, and thus, in the fourth die 100d, it may be determined that there is no stub. At this time, the first to third dies 100a to 100c which are non-target dies may not provide a certain ODT value and may be turned off. For example, ODT values A4, B4, and C4 of first to third ODT resistors R_{TT1} to R_{TT3} of the first to third dies 100a to 100c may be set to be infinite, and an ODT switch (for example, SW of FIG. 34) corresponding to each of the first to third ODT resistors R_{TT1} to R_{TT3} may be turned off. Therefore, each of the first to third ODT resistors R_{TT1} to R_{TT3} may not be connected to a source voltage terminal (for example, V_{TT} of FIG. 34), and thus, the power consumption of the non-volatile memory 10a may be reduced.

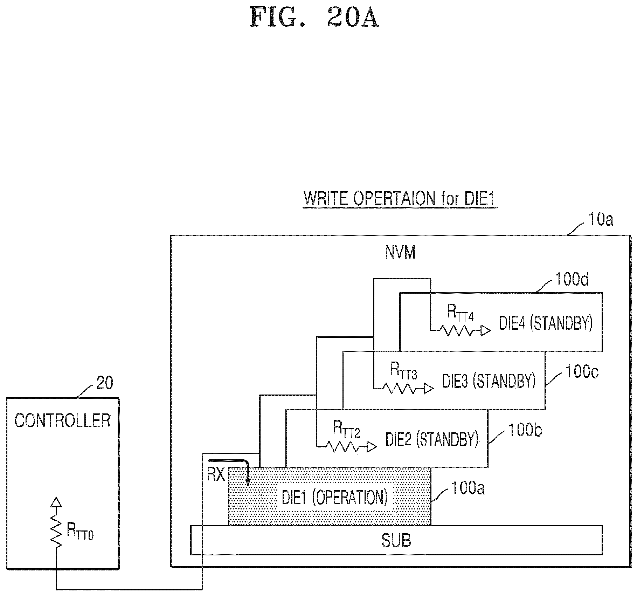

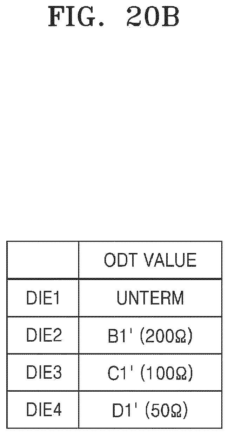

FIG. 20A illustrates a write operation of a first die 100a according to one or more embodiments, and FIG. 20B illustrates ODT values when the first die 100a is a target die.

Referring to FIGS. 20A and 20B, when performing a write operation on the first die 100a, a controller 20 may transfer a chip selection signal for selecting the first die 100a from among first to fourth dies 100a to 100d. The first die 100a may operate as a receiver RX in response to a chip selection signal, and the first die 100a may receive write data from a controller 20. At this time, write data or a data strobe signal output from the controller 20 may be reflected from the second to fourth dies 100b to 100d.

According to one or more embodiments, each of the second to fourth dies 100b to 100d may provide an ODT resistance, and thus, a signal reflected from each of the second to fourth dies 100b to 100d may be reduced. In this case, second to fourth ODT resistors R_{TT2} to R_{TT4} of the second to fourth dies 100b to 100d may have different values, based on a distance to the first die 100a which is a target die. For example, a distance may include a physical distance or an electrical distance. For example, an ODT value B1' of the second ODT resistor R_{TT2} of the second die 100b may be set to 200 Ω, an ODT value C1' of the third ODT resistor R_{TT3} of the third die 100c may be set to a value (for example, 100 Ω) which is less than B1', and an ODT value D1' of the fourth ODT resistor R_{TT4} of the fourth die 100d may be set to a value (for example, 50 Ω) which is less than B1' and C1'.

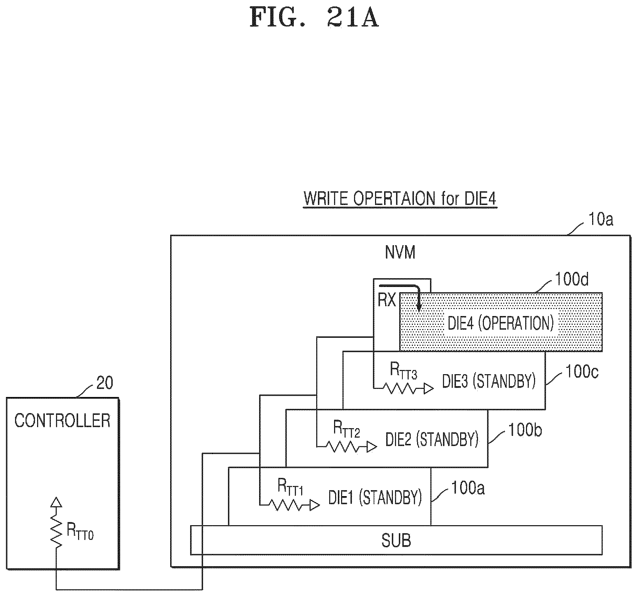

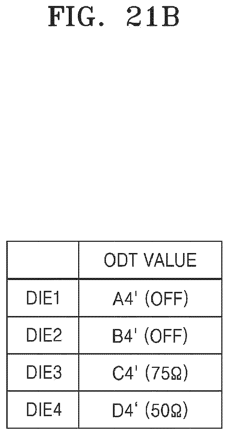

FIG. 21A illustrates a write operation of a fourth die 100d according to one or more embodiments, and FIG. 21B illustrates ODT values when the fourth die 100d is a target die.

Referring to FIGS. 21A and 21B, when performing a write operation on the fourth die 100d, the fourth die 100d may operate as a receiver RX in response to a chip selection signal, and the fourth die 100d may transfer write data to a controller 20. At this time, write data or a data strobe signal output from the controller 20 may be reflected from the first to third dies 100a to 100c.

In this case, based on power consumption and a distance to the fourth die 100d which is a target die, first to third ODT resistors R_{TT1} to R_{TT3} of the first to third dies 100a to 100c may be set to have different values. For example, a distance may include a physical distance or an electrical distance. For example, an ODT value A4' of the first ODT resistor R_{TT1} of the first die 100a which is relatively far away from the fourth die 100d in distance may be set to be infinite, and similarly, an ODT value B4' of the second ODT resistor R_{TT2} of the second die 100b may be set to be infinite. For example, an ODT value C4' of the third ODT resistor R_{TT3} of the third die 100c which is relatively close to the fourth die 100d in distance may be set to a value (for example, 75 Ω) which is less than A4' and B4'. For example, an ODT value D4' of the fourth ODT resistor R_{TT4} of the fourth die 100d may be set to a value (for example, 50 Ω) which is less than C4'.

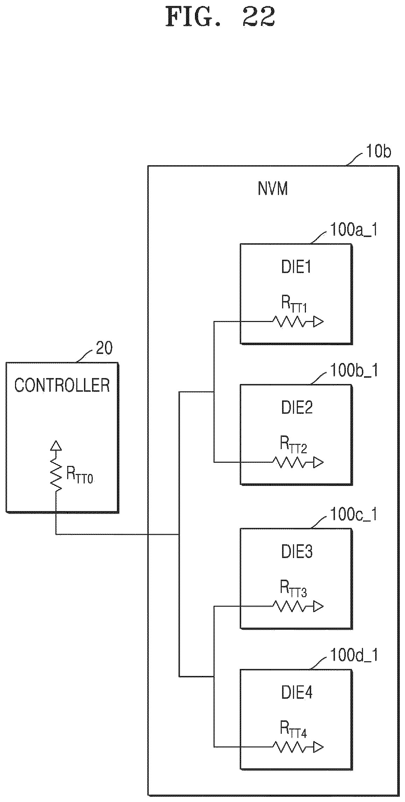

FIG. 22 illustrates a controller 20 and a non-volatile memory 10b according to one or more embodiments.

Referring to FIG. 22, the non-volatile memory 10b may include first to fourth dies 100a_1 to 100d_1. For example, the first to fourth dies 100a_1 to 100d_1 may be disposed in a horizontal direction on a substrate. For example, the first and second dies 100a_1 and 100b_1 may be stacked in a vertical direction on the substrate, and the third and fourth dies 100c_1 and 100d_1 may be stacked in the vertical direction on the substrate. The non-volatile memory 10b may correspond to an implementation example of the non-volatile memory 10a of FIG. 14, and the first to fourth dies 100a_1 to 100d_1 may have channel topology which differs from the first to fourth dies 100a to 100d of FIG. 14. Accordingly, ODT values of the first to fourth dies 100a_1 to 100d_1 may be set to be different from ODT values of the first to fourth dies 100a to 100d of FIG. 14.

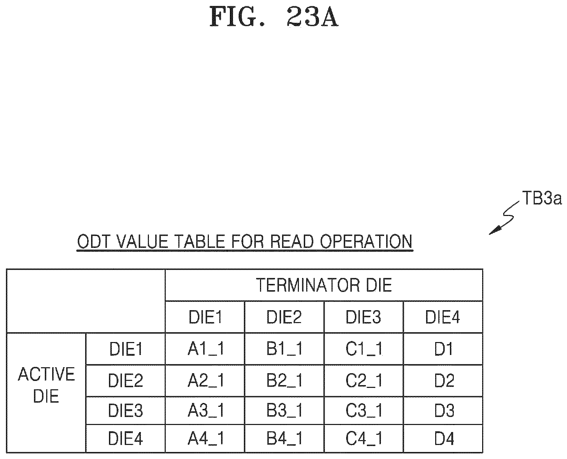

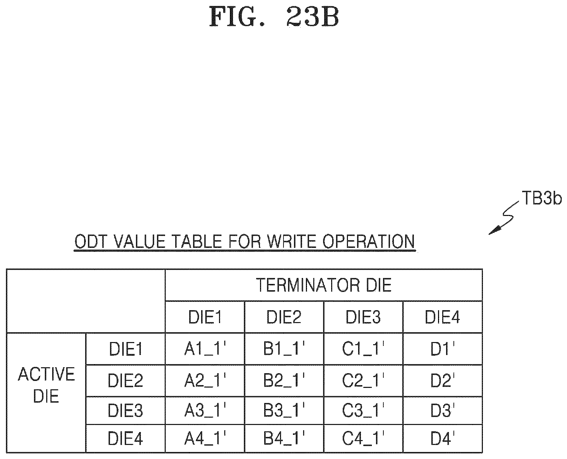

FIG. 23A shows an ODT value table TB3a for a read operation of the non-volatile memory 10b of FIG. 22, and FIG. 23B shows an ODT value table TB3b for a write operation of the non-volatile memory 10b of FIG. 22.

Referring to FIG. 23A in conjunction with FIG. 22, the ODT value table TB3a for read operation may show read ODT resistances of first to fourth dies 100a_1 to 100d_1 based on an active die, when performing a read operation on the non-volatile memory 10b. For example, a read ODT value of the first die 100a_1 may be A2_1 when an active die is the second die 100b_1, may be A3_1 when the active die is the third die 100c_1, and may be A4_1 when the active die is the fourth die 100d_1, and A2_1, A3_1, and A4_1 may differ. For example, when the first die 100a_1 is the active die, read ODT values of the second to fourth dies 100b_1 to 100d_1 may be B1_1, C1_1, and D1_1, and B1_1, C1_1, and D1_1 may differ.

Referring to FIG. 23B in conjunction with FIG. 22, the ODT value table TB3b for write operation may show write ODT resistances of first to fourth dies 100a_1 to 100d_1 based on an active die, when performing a write operation on the non-volatile memory 10b. For example, a write ODT value of the first die 100a_1 may be A2_1' when an active die is the second die 100b_1, may be A3_1' when the active die is the third die 100c_1, and may be A4_1' when the active die is the fourth die 100d_1, and A2_1', A3_1', and A4_1' may differ. For example, when the first die 100a_1 is the active die, write ODT values of the second to fourth dies 100b_1 to 100d_1 may be B1_1', C1_1', and D1_1', and B1_1', C1_1', and D1_1' may differ.

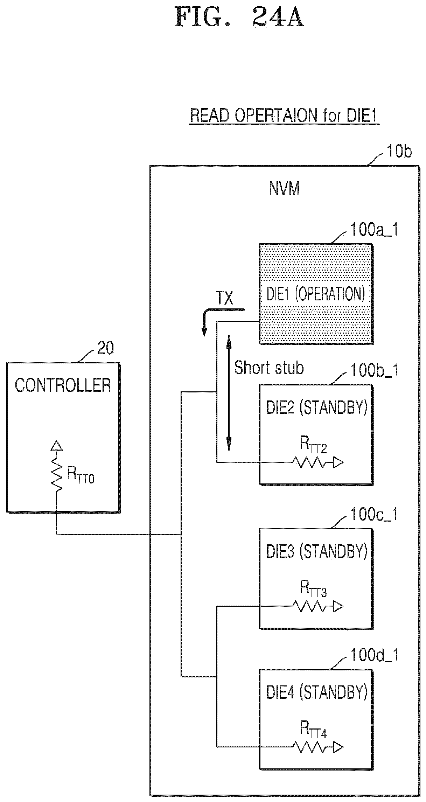

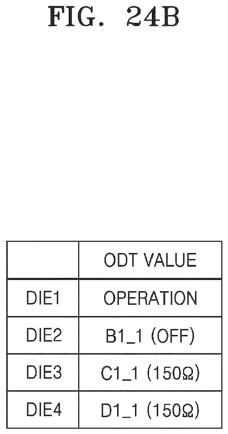

FIG. 24A illustrates a read operation of a first die 100a_1 according to one or more embodiments, and FIG. 24B illustrates ODT values when the first die 100a_1 is a target die.

Referring to FIGS. 24A and 24B, when performing a read operation on the first die 100a_1, the first die 100a_1 may operate as a transmitter TX in response to a chip selection signal, and the first die 100a_1 may transfer read data to a controller 20. At this time, read data or a data strobe signal output from the first die 100a_1 or a read enable signal received from the controller 20 may be reflected from second to fourth dies 100b_1 to 100d_1.

According to one or more embodiments, each of the second to fourth dies 100b_1 to 100d_1 may provide an ODT resistance, and thus, a signal reflected from each of the second to fourth dies 100b_1 to 100d_1 may be reduced. For example, a stub length between the first die 100a_1 and the second die 100b_1 may be relatively short, and thus, an ODT value B1_1 of a second ODT resistor R_{TT2} of the second die 100b_1 may be set to be infinite. For example, a stub length between the first die 100a_1 and the third die 100c_1 may be relatively long, and thus, an ODT value of a third ODT resistor R_{TT3} of the third die 100c_1 may be set to C1_1 (for example, 150 Ω) which is less than B1_1. For example, a stub length between the first die 100a_1 and the fourth die 100d_1 may be substantially equal to the stub length between the first die 100a_1 and the third die 100c_1, and thus, an ODT value of a fourth ODT resistor R_{TT4} of the fourth die 100d_1 may be set to D1_1 (for example, 150 Ω) which is equal to C1_1.

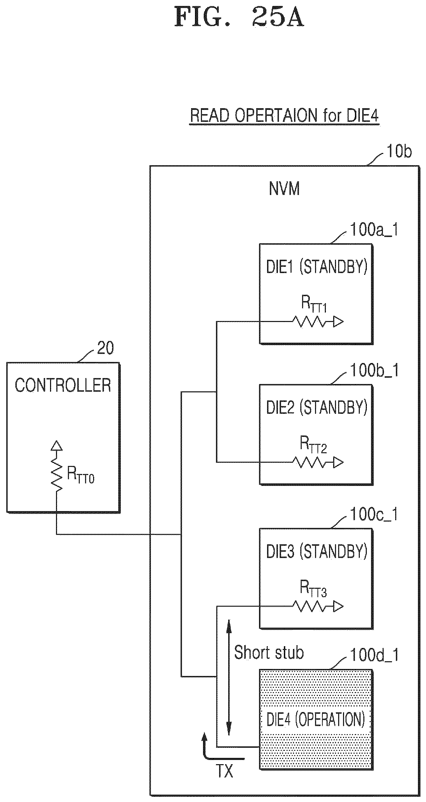

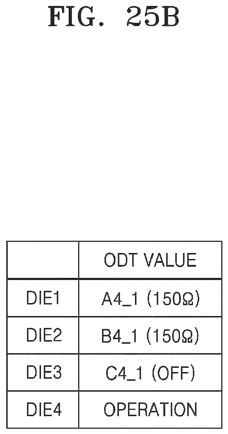

FIG. 25A illustrates a read operation of a fourth die 100d_1 according to one or more embodiments, and FIG. 25B illustrates ODT values when the fourth die 100d_1 is a target die.

Referring to FIGS. 25A and 25B, when performing a read operation on the fourth die 100d_1, the fourth die 100d_1 may operate as a transmitter TX in response to a chip selection signal, and the fourth die 100d_1 may transfer read data to a controller 20. At this time, read data or a data strobe signal output from the fourth die 100d_1 or a read enable signal received from the controller 20 may be reflected from first to third dies 100a_1 to 100c_1.

For example, a stub length between the third die 100c_1 and the fourth die 100d_1 may be relatively short, and thus, an ODT value C4_1 of a third ODT resistor R_{TT3} of the third die 100c_1 may be set to be infinite. For example, a stub length between the first die 100a_1 and the fourth die 100d_1 may be relatively long, and thus, an ODT value of a first ODT resistor R_{TT1} of the first die 100a_1 may be set to A4_1 (for example, 150 Ω) which is less than C4_1. For example, a stub length between the second die 100b_1 and the fourth die 100d_1 may be substantially equal to the stub length between the first die 100a_1 and the fourth die 100d_1, and thus, an ODT value of a second ODT resistor R_{TT2} of the second die 100b_1 may be set to B4_1 (for example, 150 Ω) which is equal to A1_1.

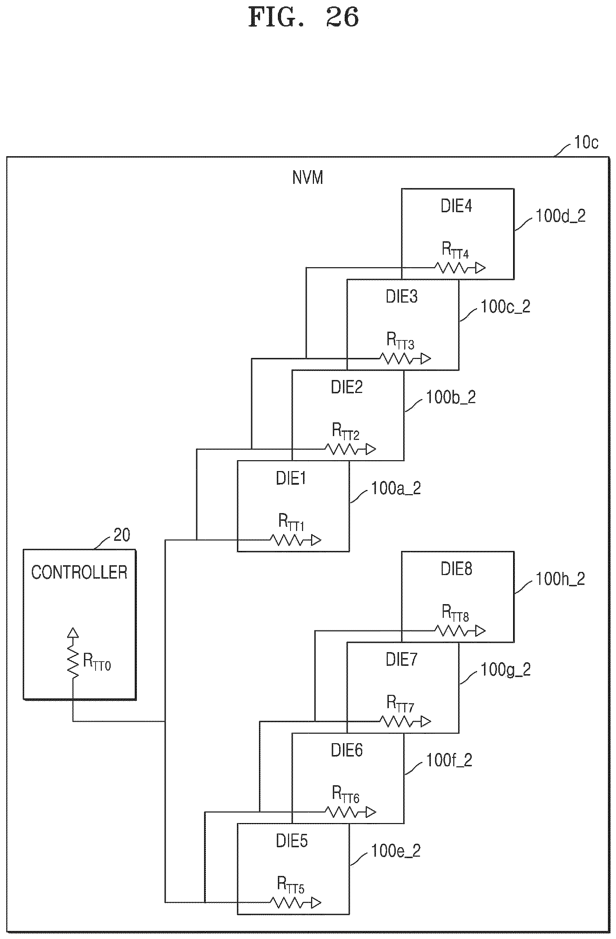

FIG. 26 illustrates a controller 20 and a non-volatile memory 10c according to one or more embodiments.

Referring to FIG. 26, the non-volatile memory 10c may include a first die 100_2, a second die 100b_2, a third die 100c_2, a fourth die 100d_2, a fifth die 100e_2, a sixth die 100f_2, a seventh die 100g_2, and an eighth die 100h_2. For example, the first to eighth dies 100a_2 to 100h_2 may be disposed in a vertical direction on a substrate. For example, the first to fourth dies 100a_2 to 100d_2 may be stacked in a vertical direction on the substrate, and the fifth to eighth dies 100e_2 to 100h_2 may be stacked in the vertical direction on the substrate. The non-volatile memory 10c may correspond to an implementation example of the non-volatile memory 10a of FIG. 14 or the non-volatile memory 10b of FIG. 22, and the first to eighth dies 100a_2 to 100h_2 may have channel topology which differs from the first to fourth dies 100a to 100d of FIG. 14 and the first to fourth dies 100a_1 to 100d_1 of FIG. 22. Accordingly, ODT values of the first to eighth dies 100a_2 to 100h_2 may be set to be different from ODT values of the first to fourth dies 100a to 100d of FIG. 14 or ODT values of the first to fourth dies 100a_1 to 100d_1 of FIG. 22.

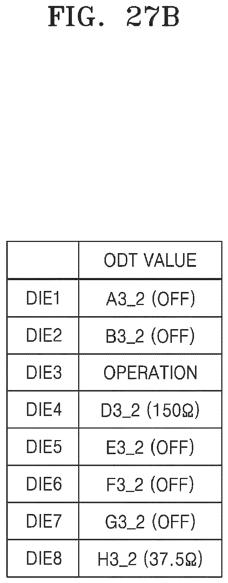

FIG. 27A illustrates a read operation of a third die 100c_2 according to one or more embodiments, and FIG. 27B illustrates ODT values when the third die 100c_2 is a target die.

Referring to FIGS. 27A and 27B, when performing a read operation on the third die 100c_2, a controller 20 may transfer a chip selection signal for selecting the third die 100c_2 from among first to eighth dies 100a_2 to 100h_2. The third die 100c_2 may operate as a transmitter TX in response to the chip selection signal, and the third die 100c_2 may transfer read data to the controller 20. At this time, read data or a data strobe signal output from the third die 100c_2 or a read enable signal received from the controller 20 may be reflected from first, second, and fourth to eighth dies 100a_2, 100b_2, and 100d_2 to 100h_2.

According to one or more embodiments, each of the first, second, and fourth to eighth dies 100a_2, 100b_2, and 100d_2 to 100h_2 may provide an ODT resistance, and thus, a signal reflected from each of the first, second, and fourth to eighth dies 100a_2, 100b_2, and 100d_2 to 100h_2 may be reduced. For example, ODT values of first and second ODT resistors R_{TT1} and R_{TT2} of the first and second dies 100a_2 and 100b_2 may be set to be infinite. For example, an ODT value of a fourth ODT resistor R_{TT4} of the fourth die 100d_2 may be set to D3_2 (for example, 150 Ω) which is less than A3_2 and B3_2. For example, ODT values of fifth to seventh ODT resistors R_{TT5} to R_{TT7} of the fifth to seventh dies 100e_2 to 100g_2 may be set to be infinite. For example, a stub length between the third die 100c_2 and the eighth die 100h_2 may be longer than a stub length between the third die 100c_2 and the fourth die 100d_2, and thus, an ODT value of an eighth ODT resistor R_{TT8} of the eighth die 100h_2 may be set to H3_2 (for example, 37.5 Ω) which is less than D3_2.

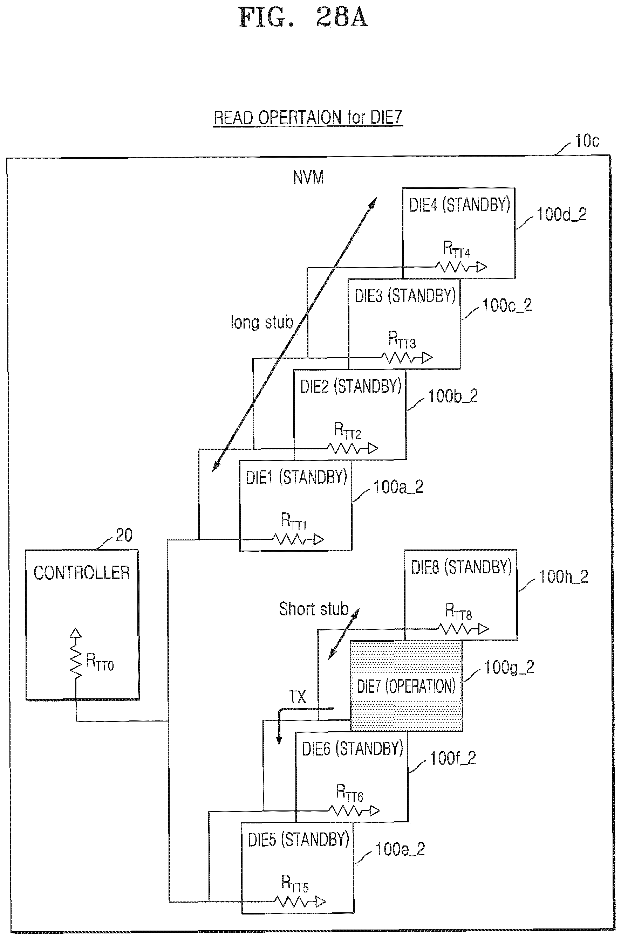

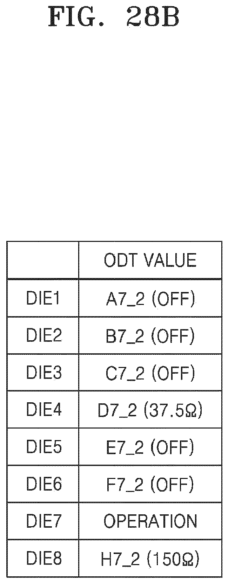

FIG. 28A illustrates a read operation of a seventh die 100g_2 according to one or more embodiments, and FIG. 28B illustrates ODT values when the seventh die 100g_2 is a target die.

Referring to FIGS. 28A and 28B, when performing a read operation on the seventh die 100g_2, the seventh die 100g_2 may operate as a transmitter TX in response to a chip selection signal, and the seventh die 100g_2 may transfer read data to a controller 20. At this time, read data or a data strobe signal output from the seventh die 100g_2 or a read enable signal received from the controller 20 may be reflected from first to sixth and eighth dies 100a_2 to 100f_2 and 100h_2.

For example, ODT values of first to third ODT resistors R_{TT1} to R_{TT3} of the first to third dies 100a_2 to 100c_2 may be set to be infinite. For example, an ODT value D7_2 of a fourth ODT resistor R_{TT4} of the fourth die 100d_2 may be set to 37.5 Ω. For example, ODT values of ODT resistors R_{TT5} and R_{TT6} of the fifth and sixth dies 100e_2 and 100f_2 may be set to be infinite. For example, a stub length between the eighth die 100h_2 and the seventh die 100g_2 may be shorter than a stub length between the fourth die 100d_2 and the seventh die 100g_2, and thus, an ODT value of an eighth ODT resistor R_{TT8} of the eighth die 100h_2 may be set to H7_2 (for example, 150 Ω) which is greater than D7_2.

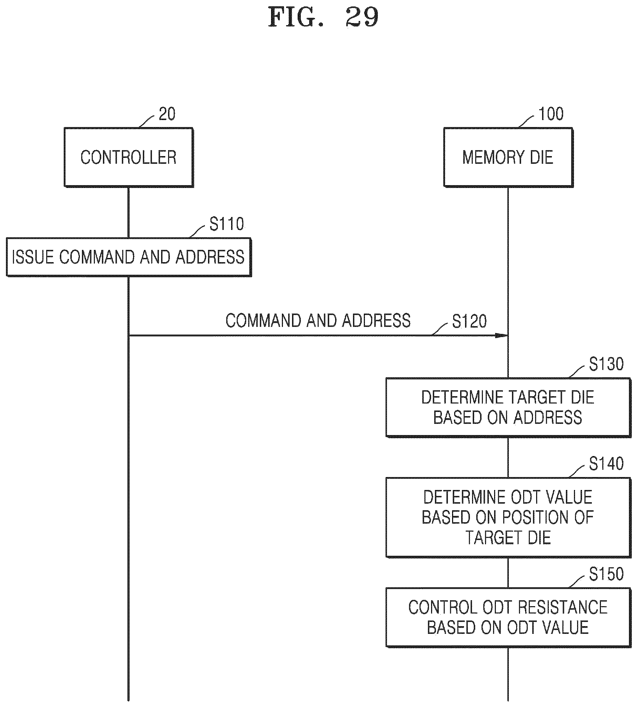

FIG. 29 is a flowchart illustrating an operation of each of a controller 20 and a memory die 100, according to one or more embodiments.

Referring to FIG. 29, in operation S110, the controller 20 may issue a command and an address. In operation S120, the controller 20 may transfer the command and the address to the memory die 100. In operation S130, the memory die 100 may determine a target die, based on the address. For example, the address may include a chip address (for example, CHIP_ADDR of FIG. 8) or an LUN address (for example, LUN_ADDR of FIG. 10). In operation S140, the memory die 100 may determine an ODT value, based on a position of the target die. For example, the memory die 100 may select an ODT value based on the target die in an ODT value table (for example, TB1 of FIG. 3) storing a plurality of ODT values. In operation S150, the memory die 100 may control an ODT resistance value, based on the selected ODT value.

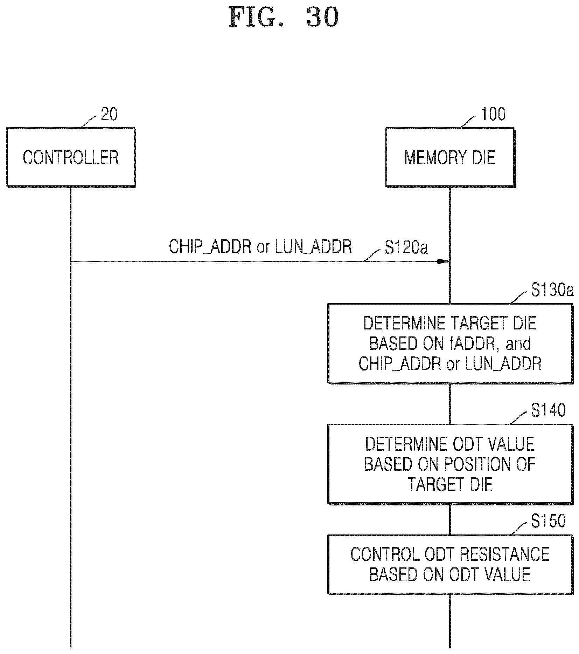

FIG. 30 is a flowchart illustrating an operation of each of a controller 20 and a memory die 100, according to one or more embodiments. A method according to one or more embodiments may correspond to an implementation example of FIG. 29.

Referring to FIG. 30, in operation S120a, the controller 20 may transfer a chip address CHIP_ADDR or an LUN address LUN_ADDR to the memory die 100. For example, in a case where the controller 20 communicates with the memory die 100 through a CER scheme, the chip address CHIP_ADDR may be transferred as some bits of the address. For example, in a case where the controller 20 communicates with the memory die 100 through an SCA scheme, the LUN address LUN_ADDR may be transferred as some bits of the command/address.

In operation S130a, the memory die 100 may determine the target die, based on a die address fADDR and the chip address CHIP_ADDR or the LUN address LUN_ADDR. In operation S140, the memory die 100 may determine an ODT value, based on a position of the target die. In operation S150, the memory die 100 may control an ODT resistance, based on the ODT value.

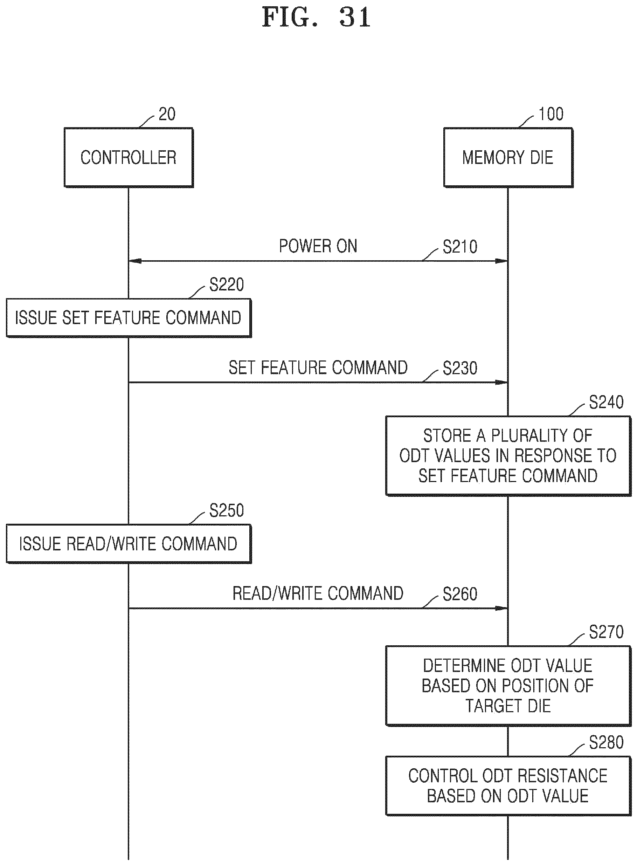

FIG. 31 is a flowchart illustrating an operation of each of a controller 20 and a memory die 100, according to one or more embodiments.

Referring to FIG. 31, in operation S210, power may be applied to the controller 20 and the memory die 100, and thus, a power-on state may be entered. In operation S220, the controller 20 may issue a set feature command for setting a plurality of ODT values. In operation S230, the controller 20 may transfer the set feature command to the memory die 100. In operation S240, the memory die 100 may store the plurality of ODT values in response to the set feature command.

In one or more embodiments, the controller 20 may transfer ODT values of all dies through a command on each die. In one or more embodiments, the controller 20 may limit ODT values to a K number and may transfer K number of ODT values through the command. For example, the controller 20 may select a die-based ODT value as one ODT value from among the K ODT values (where K may be a positive integer). For example, the controller 20 may limit ODT values to four and may select a die-based ODT value as one ODT value from among four ODT values. For example, the controller 20 may limit ODT values to two and may select a die-based ODT value as one ODT value from among two ODT values. In this case, the two ODT values may include an infinite (or open) or endpoint value. In one or more embodiments, the controller 20 may set an ODT value to a default value, and only when a change is needed, the controller 20 may transfer a corrected ODT value through the command.

In operation S250, the controller 20 may issue a read/write command. In operation S260, the controller 20 may transfer the read/write command to the memory die 100. In operation S270, the memory die 100 may determine an ODT value, based on a position of the target die. For example, the memory die 100 may select an ODT value corresponding to the target die, based on a plurality of ODT values which are previously stored. In operation S280, the memory die 100 may control an ODT resistance, based on the ODT value.

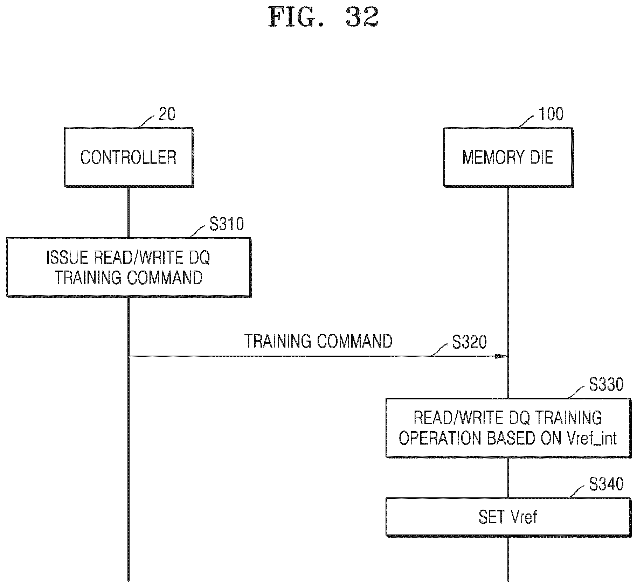

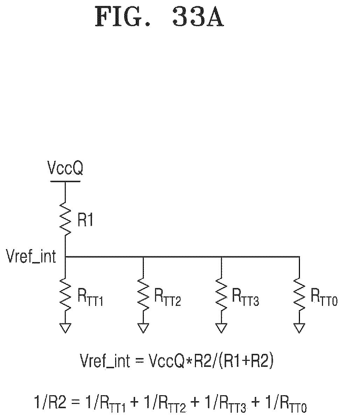

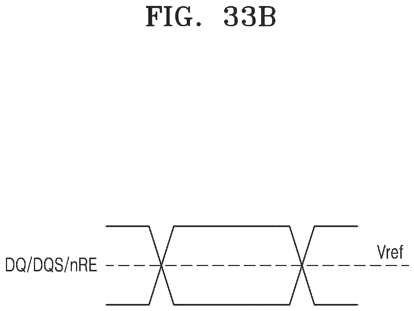

FIG. 32 is a flowchart illustrating an operation of each of a controller 20 and a memory die 100, according to one or more embodiments. FIG. 33A illustrates an equivalent circuit of an ODT resistor according to one or more embodiments, and FIG. 33B shows a timing diagram of a signal according to one or more embodiments.

Referring to FIGS. 32 to 33B, in operation S310, the controller 20 may issue a training command for read/write data training. Here, the read/write data training may be a method which re-performs data training while varying a reference voltage and compares data window sizes based on data training results of several reference voltage cases to detect optimal performance. For example, a training operation on a reference voltage corresponding to the controller 20 may be performed through read data training. For example, a training operation on a reference voltage corresponding to a non-volatile memory (i.e., memory die 100) may be performed through write data training. In operation S320, the controller 20 may transfer the training command to the memory die 100.

In operation S330, the memory die 100 may perform a read/write data training operation, based on an initial reference voltage Vref_int. For example, the equivalent circuit of FIG. 33A may be an equivalent circuit of ODT resistors of the non-volatile memory 10b and the controller 20 of FIG. 25A. In this case, R1 may correspond to a transmission driver strength of a fourth die 100d_1 which is an operation die, and R2 may be an equivalent resistor corresponding to ODT resistors R_{TT0} to R_{TT3}. Resistance values of the ODT resistors R_{TT0} to R_{TT3} may be known based on a pre-defined ODT value table, and thus, the initial reference voltage Vref_int may be set based on the resistance values of the ODT resistors R_{TT0} to R_{TT3}. In operation S340, the memory die 100 may set a reference voltage Vref, based on a performance result of the training operation. For example, a data signal DQ, a data strobe signal DQS, or a read enable signal nRE may swing with respect to the reference voltage Vref. As described above, according to one or more embodiments, by using the reference voltage Vref based on the resistance values of the ODT resistors R_{TT0} to R_{TT3}, a time consumed in the training operation may be reduced.

FIG. 34 illustrates a storage device SD3 according to one or more embodiments.

Referring to FIG. 34, the storage device SD3 may include a controller 20a and non-volatile memories 10 and 10_1. A method, which controls an ODT resistance based on an ODT value selected based on a target die from among a plurality of ODT values as described above with reference to FIGS. 1 to 33, may be applied to the non-volatile memories 10 and 10_1. The non-volatile memory 10 may communicate with the controller 20a through a first channel CH1, and the non-volatile memory 10_1 may communicate with the controller 20a through a second channel CH2. The non-volatile memory 10 may include a plurality of memory dies 100 each including an ODT circuit 110, and the non-volatile memory 10_1 may include a plurality of memory dies 100_1 each including an ODT circuit 110_1. Each of the ODT circuits 110 and 110_1 may include an ODT switch SW and an ODT resistor R_{TT}, which are serially connected to each other. The ODT switch SW may be connected between a source voltage terminal V_{TT} and the ODT resistor R_{TT}. One end of the ODT resistor R_{TT} may be connected to the ODT switch SW, and the other end may be connected to one of an I/O pin which transfers or receives a data signal DQ, a data strobe pin which transfers or receives a data strobe signal DQS, and a read enable pin which receives a read enable signal nRE.

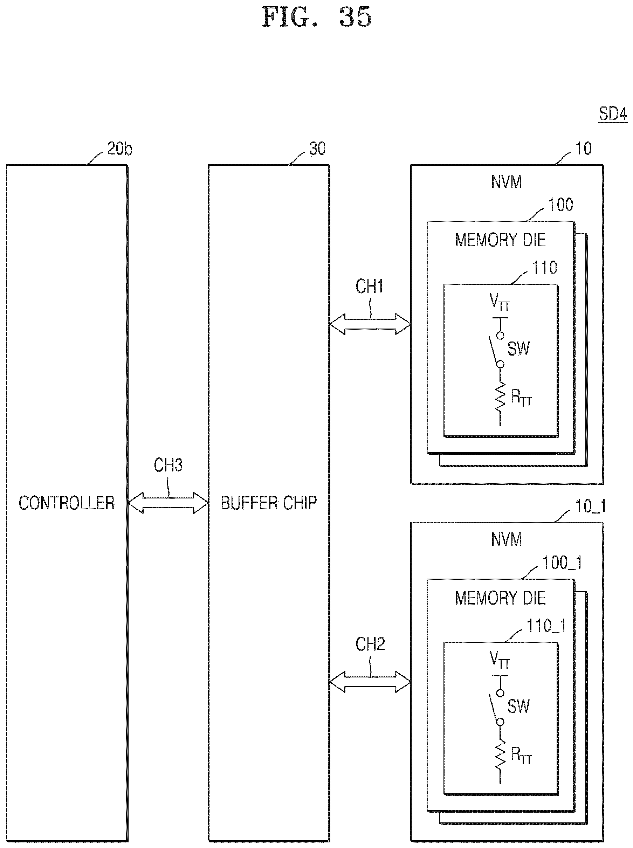

FIG. 35 illustrates a storage device SD4 according to one or more embodiments.

Referring to FIG. 35, the storage device SD4 may include a controller 20b, a buffer chip 30, and non-volatile memories 10 and 10_1. A method, which controls an ODT resistance based on an ODT value selected based on a target die from among a plurality of ODT values as described above with reference to FIGS. 1 to 33, may be applied to the non-volatile memories 10 and 10_1. The non-volatile memory 10 may communicate with the buffer chip 30 through a first channel CH1, and the non-volatile memory 10_1 may communicate with the buffer chip 30 through a second channel CH2. The buffer chip 30 may communicate with the controller 20b through a third channel CH3. The buffer chip 30 may be connected between the controller 20b and the non-volatile memories 10 and 10_1 and may be referred to as a frequency boosting interface (FBI) circuit. For example, the non-volatile memories 10 and 10_1 and the buffer chip 30 may be implemented as a single package.

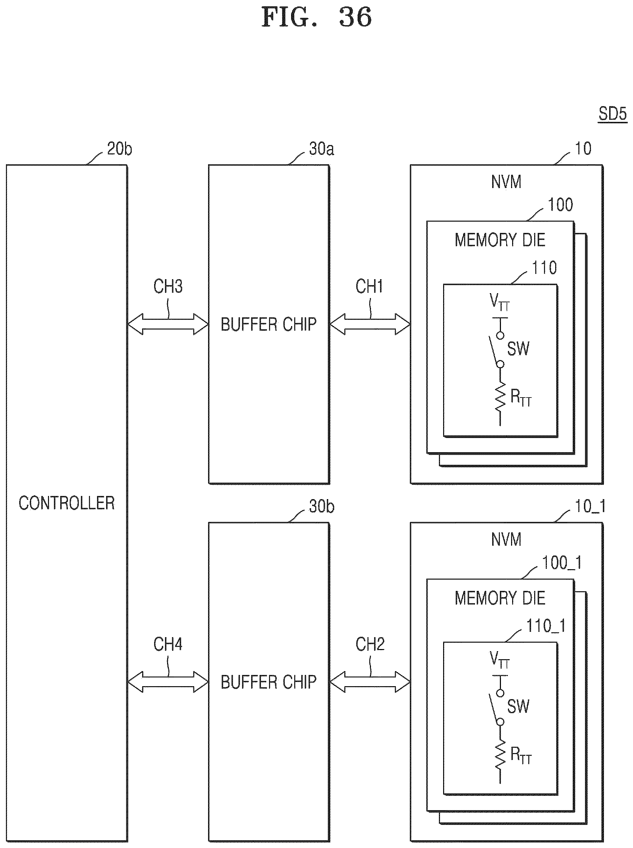

FIG. 36 illustrates a storage device SD5 according to one or more embodiments.

Referring to FIG. 36, the storage device SD5 may include a controller 20b, buffer chips 30a and 30b, and non-volatile memories 10 and 10_1. A method, which controls an ODT resistance based on an ODT value selected based on a target die from among a plurality of ODT values as described above with reference to FIGS. 1 to 33, may be applied to the non-volatile memories 10 and 10_1. The non-volatile memory 10 may communicate with the buffer chip 30a through a first channel CH1, and the non-volatile memory 10_1 may communicate with the buffer chip 30b through a second channel CH2. The buffer chip 30a may communicate with the controller 20b through a third channel CH3, and the buffer chip 30b may communicate with the controller 20b through a fourth channel CH4.

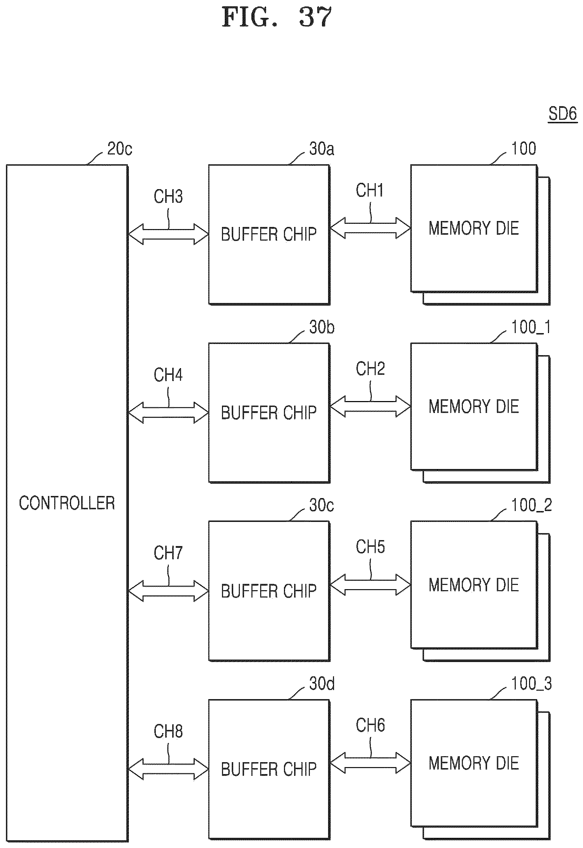

FIG. 37 illustrates a storage device SD6 according to one or more embodiments.

Referring to FIG. 37, the storage device SD6 may include a controller 20c, buffer chips 30a, 30b, 30c, and 30d, and memory dies 100, 100_1, 100_2, and 100_3. A method, which controls an ODT resistance based on an ODT value selected based on a target die from among a plurality of ODT values as described above with reference to FIGS. 1 to 33, may be applied to the memory dies 100 to 100_3. The memory dies 100 may communicate with the buffer chip 30a through a first channel CH1, the memory dies 100_1 may communicate with the buffer chip 30b through a second channel CH2, the memory dies 100_2 may communicate with the buffer chip 30c through a fifth channel CH5, and the memory dies 100_3 may communicate with the buffer chip 30d through a sixth channel CH6. The buffer chip 30a may communicate with the controller 20c through a third channel CH3, the buffer chip 30b may communicate with the controller 20c through a fourth channel CH4, the buffer chip 30c may communicate with the controller 20c through a seventh channel CH7, and the buffer chip 30d may communicate with the controller 20c through an eighth channel CH8.

At least one of the components, elements, modules or units (collectively "components" in this paragraph) represented by a block in the drawings may be embodied as various numbers of hardware, software and/or firmware structures that execute respective functions described above, according to an exemplary embodiment. For example, at least one of these components may use a direct circuit structure, such as a memory, a processor, a logic circuit, a look-up table, etc. that may execute the respective functions through controls of one or more microprocessors or other control apparatuses. Also, at least one of these components may be specifically embodied by a module, a program, or a part of code, which contains one or more executable instructions for performing specified logic functions, and executed by one or more microprocessors or other control apparatuses. Further, at least one of these components may include or may be implemented by a processor such as a central processing unit (CPU) that performs the respective functions, a microprocessor, or the like. Two or more of these components may be combined into one single component which performs all operations or functions of the combined two or more components. Also, at least part of functions of at least one of these components may be performed by another of these components. Further, although a bus is not illustrated in the above block diagrams, communication between the components may be performed through the bus. Functional aspects of the above exemplary embodiments may be implemented in algorithms that execute on one or more processors. Furthermore, the components represented by a block or processing steps may employ any number of related art techniques for electronics configuration, signal processing and/or control, data processing and the like.

Hereinabove, embodiments have been described in the drawings and the specification. Embodiments have been described by using the terms described herein, but this has been merely used for describing the embodiments and has not been used for limiting a meaning or limiting the scope as defined in the following claims. Therefore, it may be understood by those of ordinary skill in the art that various modifications may be implemented within the scope defined by the following claims. Accordingly, the scope may be defined based on the following claims.

While embodiments have been described with reference to the figures, it will be understood by those of ordinary skill in the art that various changes in form and details may be made therein without departing from the scope as defined by the following claims.

## Claims

1. A non-volatile memory device comprising:
an input/output, I/O, pin (Pn; P11; P21) configured to transfer data (DQ) to or receive data (DQ) from a memory controller (20; 20_1; 20_2); and
a plurality of memory dies (100a to 100n) connected to the I/O pin (Pn; P11; P21), the plurality of memory dies (100a to 100n) comprising a target die (e.g. 100a), a first non-target die (e.g. 100b), and a second non-target die (e.g. 100c),
wherein the first non-target die (100b) comprises a first on-die-termination, ODT, circuit (110b) connected to the I/O pin (Pn; P11; P21) and configured to provide a first ODT resistance value (R_{TT2}) based on a first distance between the target die (100a) and the first non-target die (100b), and
wherein the second non-target die (100c) comprises a second ODT circuit (110c) connected to the I/O pin (Pn; P11; P21) and configured to provide a second ODT resistance value (R_{TT3}) based on a second distance between the target die (100a) and the second non-target die (100c), the second ODT resistance value (R_{TT3}) being different from the first ODT resistance value (R_{TT2}).

2. The non-volatile memory device of claim 1, wherein each memory die of the plurality of memory dies (100a to 100n) comprises:
a detection circuit (121) configured to detect a position of the target die (100a);
a selection circuit (122) configured to select an ODT value (e.g. ODT_V2; A2) from among a plurality of ODT values (ODT_V1 to ODT_Vm; A1 to An) based on the target die (100a); and
an ODT circuit (110) configured to provide the selected ODT value (ODT_V2; A2).

3. The non-volatile memory device of claim 2, further comprising a chip enable pin (P14; P24) configured to receive a chip enable signal (nCE) from the memory controller (20; 20_1; 20_2),
wherein the detection circuit (121) is configured to detect a position of the target die (100a) based on the chip enable signal (nCE).

4. The non-volatile memory device of claim 3, wherein the I/O pin (P11) is further configured to receive a command (CMD) and an address (ADDR) from the memory controller (20_1), and
wherein the detection circuit (121) is configured to detect a position of the target die (100a) based on the chip enable signal (nCE) and the address (ADDR).

5. The non-volatile memory device of claim 2, further comprising a command/address pin (P25) configured to receive a command/address (CA) from the memory controller (20_2),
wherein the detection circuit (121) is configured to detect a position of the target die (100a) based on the command/address (CA).

6. The non-volatile memory device of claim 5, further comprising a chip enable pin (P24) configured to receive a chip enable signal (nCE) from the memory controller (20; 20_2),
wherein the detection circuit (121) is configured to detect a position of the target die (100a) based on the chip enable signal (nCE) and the command/address (CA).

7. The non-volatile memory device of claim 1 or 2, further comprising a chip enable pin (P14) configured to receive a chip enable signal (nCE) from the memory controller (20_1),
wherein the I/O pin (P11) is further configured to receive a command (CMD) and an address (ADDR) from the memory controller (20_1),
wherein the target die (100a) is selected based on the chip enable signal (nCE) and the address (ADDR), and
wherein the first non-target die (100b) and the second non-target die (100c) are not selected based on the chip enable signal (nCE) and the address (ADDR).

8. The non-volatile memory device of claim 1 or 2, further comprising:
a chip enable pin (P24) configured to receive a chip enable signal (nCE) from the memory controller (20_2); and
a command/address pin (P25) configured to receive a command/address (CA) from the memory controller (20_2),
wherein the target die (100a) is selected based on the chip enable signal (nCE) and the command/address (CA), and
wherein the first non-target die (100b) and the second non-target die (100c) are not selected based on the chip enable signal (nCE) and the command/address (CA).

9. The non-volatile memory device of any one of claims 2 to 8, wherein each memory die of the plurality of memory dies (100a to 100n) further comprises a storage circuit (123) configured to store the plurality of ODT values (ODT_V1 to ODT_Vm; A1 to An).

10. The non-volatile memory device of claim 9, wherein each memory die of the plurality of memory dies (100a to 100n) further comprises a memory cell array, and
wherein the storage circuit (123) is in a partial region of the memory cell array.

11. The non-volatile memory device of claim 9 or 10, wherein, based on the non-volatile memory device (10; 10_1; 10_2) being powered up, each memory die of the plurality of memory dies (100a to 100n) is configured to receive the plurality of ODT values (ODT_V1 to ODT_Vm; A1 to An) from the memory controller (20; 20_1; 20_2) and store the received plurality of ODT values in the storage circuit (123).

12. The non-volatile memory device of claim 9 or 10, wherein each memory die of the plurality of memory dies (100a to 100n) is configured to further receive changed ODT values from the memory controller (20; 20_1; 20_2) and update the changed ODT values in the storage circuit (123).

13. The non-volatile memory device of claim 9 or 10, wherein each of the plurality of memory dies (100a to 100n) is configured to update the plurality of ODT values (ODT_V1 to ODT_Vm; A1 to An) in the storage circuit (123) based on a result of a training operation.

14. The non-volatile memory device of any one of claims 2 to 13, wherein each memory die of the plurality of memory dies (100a to 100n) further comprises a plurality of address pins (Pa, Pa' or Pb, Pb' or Pc, Pc' or Pd, Pd') configured to receive a plurality of die addresses (fADDR), respectively, and
wherein the plurality of memory dies (100a to 100n) respectively correspond to the plurality of die addresses (fADDR), respectively.

15. The non-volatile memory device of claim 14, wherein the detection circuit (121) is configured to detect a position of the target die (100a) based on a die address (fADDR), among the plurality of die addresses (fADDR), corresponding to the target die (100a).
